(19) Europäisches Patentamt
European Patent Office
Office européen des brevets

(11) **EP 3 829 088 B1**

(12) **EUROPEAN PATENT SPECIFICATION**

(45) Date of publication and mention
of the grant of the patent:
**17.01.2024 Bulletin 2024/03**

(51) International Patent Classification (IPC):
**H04L 1/00** *(2006.01)*

(21) Application number: **19824821.3**

(22) Date of filing: **24.05.2019**

(52) Cooperative Patent Classification (CPC):
**H03M 13/1111; H03M 13/114; H03M 13/116;
H04L 1/0052; H04L 1/0057**

(86) International application number:
**PCT/CN2019/088398**

(87) International publication number:
**WO 2020/001212 (02.01.2020 Gazette 2020/01)**

(54) **DECODER, DECODING METHOD, AND COMPUTER STORAGE MEDIUM**

DECODIERER, DECODIERUNGSVERFAHREN UND COMPUTERSPEICHERMEDIUM

DÉCODEUR, PROCÉDÉ DE DÉCODAGE ET SUPPORT D'ENREGISTREMENT INFORMATIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.06.2018 CN 201810717244**

(43) Date of publication of application:
**02.06.2021 Bulletin 2021/22**

(73) Proprietor: **ZTE Corporation
shenzhen Guangdong 518057 (CN)**

(72) Inventors:
• **ZHANG, He**
**Shenzhen, Guangdong 518057 (CN)**
• **ZHANG, Wei**
**Shenzhen, Guangdong 518057 (CN)**
• **WANG, Hongzhan**
**Shenzhen, Guangdong 518057 (CN)**
• **YU, Jinqing**
**Shenzhen, Guangdong 518057 (CN)**
• **PENG, Lijian**
**Shenzhen, Guangdong 518057 (CN)**

(74) Representative: **WBH Wachenhausen
Patentanwälte PartG mbB
Müllerstraße 40
80469 München (DE)**

(56) References cited:
CN-A- 1 825 770          CN-A- 1 956 368
CN-A- 101 867 449        CN-A- 103 973 315
US-A1- 2010 037 121      US-A1- 2013 173 982
US-A1- 2017 230 058

• LIGUANG LI (ZTE CORPORATION): "LDPC
Coding for 45GHz ;
11-14-0807-00-00aj-ldpc-coding-for-45ghz", IEEE
DRAFT;
11-14-0807-00-00AJ-LDPC-CODING-FOR-45GHZ
, IEEE-SA MENTOR, PISCATAWAY, NJ USA, vol.
802.11aj, 14 July 2014 (2014-07-14), pages 1-22,
XP068069537, [retrieved on 2014-07-14]

## Description

### TECHNICAL FIELD

This application relates to, but not limited to, the technical field of decoders for Quasi-Cyclic Low-Density Parity-Check (QC-LDPC) codes in wireless communication.

### BACKGROUND

With the continuous development of technologies of multimedia broadcasting, wireless communication and Very Large-Scale Integration (VLSI), Low-Density Parity-Check (LDPC) code as the forward error correction (FEC) code closest to Shannon limit has been selected as a data channel coding scheme for enhance mobile broadband (eMBB) service in the future 5th-Generation mobile communication technology (5G).

LDPC has been widely used in communication systems such as Digital Video Broadcasting (DVB), Wireless Local Area Networks (WLAN), Worldwide Interoperability for Microwave Access (WiMAX ), and etc., and are confronting with challenges from satisfying the service requirements of large capacity, low delay, high reliability and various application scenario requirements in the future 5G mobile communication system, the design of a LDPC decoder with high-performance, low-cost and flexibility has become a main technical challenge in this field.

To satisfy the requirements on high performance of bit error rate (BER) and throughput rate, the LDPC decoder is required to have a block error rate (BLER) at least lower than 1E-3 and a throughput rate up to 10 Gbps~20 Gbps. Reliable and complex decoding algorithm is required to guarantee the BER performance, and very low decoding delay is required to improve the throughput rate. At present, the LDPC decoders in the industry mostly use the standard layered-decoding method, and consequently have the problem of storage access conflict in an iterative decoding process, leading to high decoding delay and low throughput rate, and bringing up difficulties in meeting the requirements of low delay. Therefore, there exists a technical problem of low decoding efficiency in the use of the standard layered-decoding method in LDPC decoding methods of existing technologies.

The document US2017230058A1 discloses an encoding method, decoding method, encoding device and decoding device for structured LDPC codes. The method includes: determining a basic matrix used for encoding, which includes K0 up-and-down adjacent pairs; and according to the basic matrix and an expansion factor corresponding to the basic matrix, performing an LDPC encoding operation of obtaining a codeword of Nb×z bits according to source data of (Nb-Mb)×z bits, herein z is the expansion factor, and z is a positive integer which is greater than or equal to 1. The provided technical solution is applicable to the encoding and decoding of the structured LDPC, thereby realizing the encoding and decoding of LDPC at the high pipeline speed.

### SUMMARY

In view of this, a decoder, a decoding method and a computer storage medium are provided according to embodiments of the disclosure.

The technical schemes in the embodiments of the disclosure are implemented as follows.

In an aspect of the disclosure, a decoder according to an embodiment of the disclosure includes at least one computing unit, where the computing unit is configured to: acquire soft bit information to be decoded of a variable node n in a layer of a basic matrix of a low-density parity-check, LDPC, code, where n is an integer greater than or equal to 0 and less than an amount of columns b of the basic matrix; determine whether an amount of decoding iterations i of the LDPC code is less than a preset decoding iteration threshold; in response to the amount of decoding iterations i being determined less than the preset decoding iteration threshold, determine whether an amount of decoding layers k of the LDPC code is less than an amount of rows a of the basic matrix; in response to the amount of decoding layers k of the LDPC code being determined less than the amount of rows a of the basic matrix, determine soft bit information of a variable node n in a $k^{th}$ layer of the basic matrix according to the soft bit information of a variable node n in a $(k-1)^{th}$ layer of the basic matrix, a check node information from a variable node n to a check node m in a $k^{th}$ layer of the basic matrix in a decoding iteration $(i-1)^{th}$ and a check node information from the variable node n to the check node m in the $k^{th}$ layer of the basic matrix, and determine variable node information from a variable node n to a check node m in a $(k+1)^{th}$ layer of the basic matrix according to the soft bit information of the variable node n in the $(k-1)^{th}$ layer of the basic matrix and a check node information from a variable node n to a check node m in a $(k+1)^{th}$ layer of the basic matrix in the decoding iteration $(i-1)^{th}$; determine check node information from the check node m to the variable node n in the $(k+1)^{th}$ layer of the basic matrix according to variable node information of all variable nodes connected to the check node m in the $(k+1)^{th}$ layer except the variable node n; update the amount of decoding layers k to k+1, and re-determine whether the amount of decoding layers k of the LDPC code is less than the amount of rows a of the basic matrix; and in response to the amount of decoding layers k being determined greater than or equal to the amount of rows a of the basic matrix, update the amount of decoding iterations i to i+1, and re-determine whether the amount of decoding iterations i of the LDPC code is less than the preset decoding iteration threshold, until the amount of decoding iterations i is equal to the preset decoding iteration threshold, determine the soft bit information of the variable node n in the $k^{th}$ layer as a decoding result of the soft bit information to be decoded of the variable node n in the basic matrix; where, when i has an initial value of 0, k has an initial value of 0, and, when k=0 or 1, the soft bit information of the variable node n in the $k-1^{th}$ layer is the soft bit information to be decoded of the variable node n in the basic matrix.

In another aspect of the disclosure, a decoding method is applied in at least one computing unit of a decoder, and the method includes: acquiring soft bit information to be decoded of a variable node n in a layer of a basic matrix of a low-density parity-check, LDPC, code, where n is an integer greater than or equal to 0 and less than an amount of columns b of the basic matrix; determining whether an amount of decoding iterations i of the LDPC code is less than a preset decoding iteration threshold; in response to the amount of decoding iterations i being determined less than the preset decoding iteration threshold, determining whether an amount of decoding layers k of the LDPC code is less than an amount of rows a of the basic matrix; in response to the amount of decoding layers k of the LDPC code being determined less than the amount of rows a of the basic matrix, determining soft bit information of a variable node n in a $k^{th}$ layer of the basic matrix according to the soft bit information of a variable node n in a $(k-1)^{th}$ layer of the basic matrix, a check node information from a variable node n to a check node m in a $k^{th}$ layer of the basic matrix in a decoding iteration $(i-1)^{th}$ and a check node information from the variable node n to the check node m in the $k^{th}$ layer of the basic matrix, and determining variable node information from a variable node n to a check node m in a $(k+1)^{th}$ layer of the basic matrix according to the soft bit information of the variable node n in the $(k-1)^{th}$ layer of the basic matrix and a check node information from a variable node n to a check node m in a $(k+1)^{th}$ layer of the basic matrix in the decoding iteration $(i-1)^{th}$; determining check node information from the check node m to the variable node n in the $(k+1)^{th}$ layer of the basic matrix according to variable node information of all variable nodes connected to the check node m in the $(k+1)^{th}$ layer except the variable node n; updating the amount of decoding layers k to k+1, and re-determining whether the amount of decoding layers k of the LDPC code is less than the number of rows a of the basic matrix; and in response to the number of decoding layers k being determined greater than or equal to the amount of rows a of the basic matrix, updating the number i of decoding iterations to i+1, re-determining whether the amount of decoding iterations i of the LDPC code is less than the preset decoding iteration threshold until the amount of decoding iterations i is equal to the preset decoding iteration threshold, and determining the soft bit information of the variable node n in the $k^{th}$ layer as a decoding result of the soft bit information to be decoded of the variable node n in the basic matrix; where, when i has an initial value of 0, k has an initial value of 0, and when k=0 or 1, the soft bit information of the variable node n in the $k-1^{th}$ layer is the soft bit information to be decoded of the variable node n in the basic matrix.

In yet another aspect of the disclosure, a computer storage medium has a computer program stored thereon that, when executed by a processor, causes the processor to perform the decoding methods according to one or more of the embodiments described above.

The embodiments of the present disclosure provide the decoder, decoding method and computer storage medium. First of all, the decoder includes a computing unit, and the computing unit is configured to acquire soft bit information to be decoded of a variable node n in a basic matrix of a LDPC code, and determine whether an amount of decoding iterations i of the LDPC code is less than a preset decoding iteration threshold; if i is less than the preset decoding iteration threshold, determine whether an amount of decoding layers k of the LDPC code is less than an amount of rows a of the basic matrix; if k of is less than a, determine soft bit information of a variable node n in a $k^{th}$ layer of the basic matrix, and determine variable node information from a variable node n to a check node m in a $(k+1)^{th}$ layer of the basic matrix according to the soft bit information of the variable node n in the $(k-1)^{th}$ layer of the basic matrix, and determine check node information from the check node m to the variable node n in the $(k+1)^{th}$ layer of the basic matrix according to the variable node information from the variable node n to the check node m in the $(k+1)^{th}$ layer of the basic matrix. In this way, while the soft bit information of the variable nodes of the $k^{th}$ layer is obtained, the variable node information of next layer is generated, and in turn the check node information of next layer is generated. Compared with existing technologies, generating the variable node information and the check node information of next layer in advance, namely preparation is made for generating the soft bit information of the variable node n of next layer, the decoding speed is thus speeded up. While the soft bit information of the variable node n of the $k^{th}$ layer is obtained, k is updated to k+1, and the decoding of next layer is performed until the decoding of layer a is completed. The iteration number i is updated to i+1, and the iteration is performed until the iteration number is equal to the preset iteration number, thereby obtaining the soft bit information. In other words, in the embodiments of the present disclosure, while the soft bit information of the variable node n in the $k^{th}$ layer of the basic matrix is generated, the generation of the variable node information of next layer is initiated, and in turn the check node information of next layer is generated. In this way, on this basis, when the decoding of the $(k+1)^{th}$ layer is performed, the soft bit information of the variable node n in the $(k+1)^{th}$ layer of the basic matrix can be determined directly according to the soft bit information of the variable node n in the $k^{th}$ layer. Compared with existing technologies, the computing of the variable node information of the $k+1^{th}$ layer and the check node information of the $(k+1)^{th}$ layer can be started without waiting until the generation of the soft bit information of the variable node n in the $k^{th}$ layer is completed, whereby the decoding speed is improved, and the decoding efficiency of LDPC decoding is consequently improved.

**BRIEF DESCRIPTION OF DRAWINGS**

Fig. 1 is a schematic diagram of an optional structure of a decoder in an embodiment of the present disclosure;

Fig. 2 is a schematic diagram of an optional structure of a computing unit in an embodiment of the present disclosure;

Fig. 3 is a schematic diagram of an optional layout of a basic matrix in an embodiment of the present disclosure;

Fig. 4 is a schematic diagram of an optional storage format of a storage unit in an embodiment of the present disclosure;

Fig. 5 is a schematic diagram of an optional structure of a storage unit in an embodiment of the present disclosure;

Fig. 6 is a schematic diagram of an optional structure of a shift unit in an embodiment of the present disclosure;

Fig. 7 is a schematic diagram of an optional structure of a routing unit in an embodiment of the present disclosure;

Fig. 8 is a schematic diagram of an optional flow line of layered-decoding in an embodiment of the present disclosure;

Fig. 9 is a schematic diagram of an optional flow line of layer overlapped-decoding in an embodiment of the present disclosure;

Fig. 10 is a schematic flowchart of a decoding method in an embodiment of the present disclosure; and

Fig. 11 is a schematic structural diagram of a computer storage medium in an embodiment of the present disclosure.

**DETAILED DESCRIPTION**

The embodiments of the disclosure will be further described below in detail with reference to the accompanying drawings.

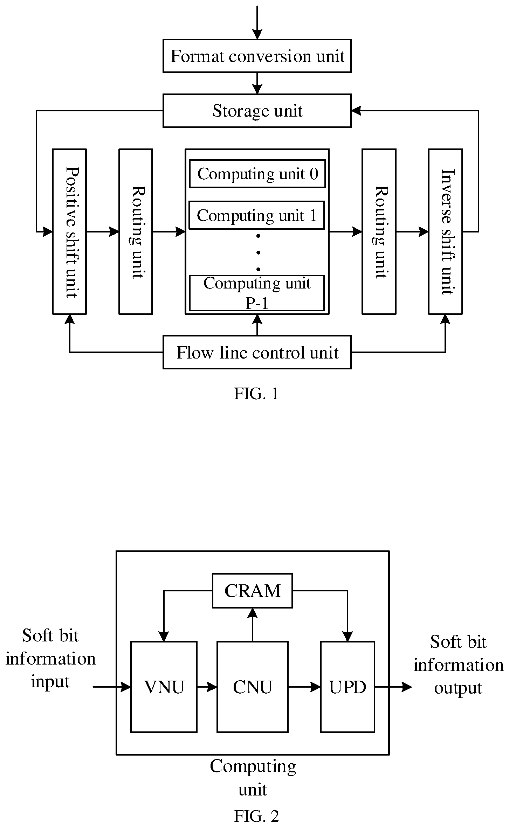

In a related standard layered-decoding method, in each iterative computation, the soft bit information of the current layer needs to be updated before the computation of variable node information of next layer, which may reduce the decoding speed of LDPC decoding. According to an embodiment of the present disclosure, a decoder is provided. Fig. 1 is a schematic diagram of an optional structure of the decoder in the embodiment of the present disclosure. Referring to Fig. 1, the decoder may include: a format conversion unit, a storage unit, a positive shift unit, an inverse shift unit, a routing unit, a flow line control unit and P computing units, and the P computing units are numbered from 0 to P-1 in turn. P is the parallelism of the decoder, the number of positive shift units is equal to the number of storage units, and the number of inverse shift units is equal to the number of storage units, and the number of storage units is a positive integer greater than or equal to 2.

The computing unit is configured to acquire soft bit information to be decoded of a variable node n in a basic matrix of a LDPC code, where n is an integer greater than or equal to 0 and less than a number of column b of the basic matrix. The computing unit is configured to determine whether an amount of decoding iterations i of the LDPC code is less than a preset decoding iteration threshold. The computing unit is configured to determine whether an amount of decoding layers k of the LDPC code is less than an amount of rows a of the basic matrix in response to the amount of decoding iterations i being less than the preset decoding iteration threshold; The computing unit is configured to determine soft bit information of a variable node n in a $k^{th}$ layer of the basic matrix according to soft bit information of a variable node n in a $(k-1)^{th}$ layer of the basic matrix in response to the amount of decoding layers k of the LDPC code less than the amount of rows a of the basic matrix, and determine variable node information from a variable node n to a check node m in a $(k+1)^{th}$ layer of the basic matrix according to the soft bit information of the variable node n in the $(k-1)^{th}$ layer of the basic matrix. The computing unit is configured to determine check node information from the check node m to the variable node n in the $(k+1)^{th}$ layer of the basic matrix according to the variable node information from the variable node n to the check node m in $(k+1)^{th}$ layer of the basic matrix. The computing unit is configured to update the amount of decoding layers k to k+1, and re-determine whether the amount of decoding layers k of the LDPC code is less than the amount of rows a of the basic matrix. The computing unit is configured to update the amount of decoding iterations i to i+1 in response to the amount of decoding layers k being greater than or equal to the amount of rows a of the basic matrix, re-determine whether the amount of decoding iterations i of the LDPC code is less than the preset decoding iteration threshold until the amount of decoding iterations i is equal to the preset decoding iteration threshold, and determine the soft bit information of the variable node n in the $k^{th}$ layer as a decoding result of the soft bit information to be decoded of the variable node n. Where, when i has an initial value of 0, k has an initial value of 0, and when k=0 or 1, the soft bit information of the variable node n in the $(k-1)^{th}$ layer is the soft bit information to be decoded of the variable node n.

Here, the QC-LDPC code is generally represented by a basic matrix H(a × b) and Z-dimensional identity matrix and its cyclic shift matrix, an extended matrix H(Z*a × Z*b) which is obtained from and represented by the basic matrix H(a × b) and Z-dimensional identity matrix and its cyclic shift matrix or zero matrix, is a sparse parity-check matrix of the QC-LDPC code. The matrix includes Z*a check nodes and Z*b variable nodes. Z is also known as an extension factor of the basic matrix, and Z is a positive integer.

For ease of description, i is defined as the index of iteration times, which may represent the iterations from the first iteration to the maximum Max_iter iteration; k is defined as the layer index of the basic matrix H(a × b), which may represent the layers from the $0^{th}$ layer to the $a-1^{th}$ layer; m is defined as the check row index in a layer of the basic matrix, which may represent the rows from the $1^{st}$ to the $Z^{th}$ row; n is defined as the index of variable node in the $k^{th}$ layer, and n' is defined as the index of variable node in the $(k+1)^{th}$ layer, $n \in N(m)$ represents the set of all variable node indexes n connected to the check node m, and similarly to $n' \in N(m)$, where 0≤n≤b-1, and 0≤n'≤b-1; $Q_n^k$ is defined as the prior information of the variable node n in the $k^{th}$ layer; $Q_{mn}^k$ is defined as the variable node information from the variable node n to the check node m in the $k^{th}$ layer; $R_{mn}^{old,k}$ is defined as the old check node information from the check node m to the variable node n in the $k^{th}$ layer, and similarly, $R_{mn}^{new,k}$ is defined as the new check node information from the check node m to the variable node n in the $k^{th}$ layer.

Specifically, the computing unit may acquire the soft bit information to be decoded of the variable node n in the basic matrix of the LDPC code from the preprocessing unit of the decoder. Before acquiring, the preprocessing unit must first determine and generate the soft bit information to be decoded of the variable node n. In order to generate the soft bit information to be decoded of the variable node n, in an optional embodiment, the decoder further includes a preprocessing unit connected to the computing unit. Before the computing unit acquires the soft bit information to be decoded of the variable node n, the preprocessing unit correspondingly determines the soft bit information to be decoded of the variable node n, a process of which may include: acquiring soft bit information to be decoded; and preprocessing the soft bit information to be decoded to obtain the soft bit information to be decoded of the variable node n.

The above preprocessing may include format converting, storing, shifting and routing for the soft bit information to be decoded, so that the computing unit may have the soft bit information to be decoded of the variable node n. In order to preprocess the soft bit information to be decoded, in an optional embodiment, the preprocessing unit may include a format conversion unit, a routing unit, at least one positive shift unit and at least one storage unit; where the format conversion unit is connected to the at least one storage unit, the at least one storage unit is connected to the at least one positive shift unit, the at least one positive shift unit is connected to the at least one routing unit, the at least one routing unit is connected to the at least one computing unit, and the flow line control unit is connected to the at least one positive shift unit and the at least one computing unit respectively, and the positive shaft unit corresponds to the storage unit in an one to one manner. Accordingly, the preprocessing unit preprocesses the soft bit information to be decoded to obtain the soft bit information to be decoded of the variable node n, a process of which may include the following operations.

The format conversion unit performs block division on the soft bit information to be decoded to obtain at least one soft bit information block to be decoded, and sends the at least one soft bit information block to the corresponding storage unit for storage; the storage unit receives the corresponding soft bit information blocks to be decoded and stores them in groups; the flow line control unit, after determining that the positive shift unit receives the soft bit information to be decoded, triggers the positive shift unit, and the positive shift unit performs positive cyclic shift on the soft bit information to be decoded to obtain the shifted soft bit information to be decoded.

The routing unit outputs the shifted soft bit information to be decoded to at least one computing unit according to a preset routing mode, allowing the computing unit to have the soft bit information to be decoded of the variable node n.

Specifically, the format conversion unit is configured to divide the input soft bit information of a code word to be decoded with a length of Z*b into b soft bit information blocks, each of which contains Z soft bit information and corresponds to a Z-dimensional extended sub-matrix. At the same time, the format conversion unit stores each soft bit information block in a preset format according to the values of parallelism P and Z, and inputs the soft bit information blocks which are format converted into the storage unit. In a process of the format conversion, the soft bit information blocks may be processed by a ping-pong mode.

The storage units are configured to store soft bit information blocks to be decoded, each storage unit stores one or more soft bit information blocks, and may provide P soft bit information blocks at the same time for parallel computing of P check rows. The number of the storage units $n_v$ may be less than or equal to an amount of basic matrix columns b according to the orthogonal characteristics of the basic matrix columns.

The flow line control unit is configured to determine that the positive shift unit receives the soft bit information to be decoded, and trigger the positive shift unit. The positive shift unit is configured to shift, rotate and output the soft bit information output by the storage unit. The positive shift unit includes $n_v$ shift units, each of which receives P soft bit information output by the corresponding storage unit, and completes the positive cyclic shift output of P soft bit information according to a preset shift value.

The routing unit is mainly configured to transmit P soft bit information output by each shift unit to data receiving ports of a variable node unit (VNU) in the computing unit according to a fixed routing connection mode, or configured to transmit soft bit information output by each data port of soft bit information update unit (UPD) of a variable node to each inverse shift unit according to a fixed routing connection mode, where each inverse shift unit receives P soft bit information.

To reduce the number of storage units and consequently the consumption of hardware resources, in an optional embodiment, performing by the format conversion unit, block division on the soft bit information to be decoded to obtain at least one soft bit information to be decoded, and sending the at least one soft bit information block to the corresponding storage unit for storage, may include dividing the soft bit information to be decoded into b soft bit information blocks to be decoded according to the amount of columns b of the basic matrix. Each soft bit information block to be decoded corresponds to an element value of the $n^{th}$ column of the basic matrix; and storing the soft bit information blocks to be decoded corresponding to the columns with orthogonality in the basic matrix in the same storage unit from the b soft bit information blocks to be decoded.

That is to say, after the b soft bit information blocks to be decoded are obtained, each soft bit information block to be decoded corresponds to the element value of each column in the basic matrix, and which columns in the basic matrix have orthogonality is determined, where the columns with orthogonality refer to any two columns that are not simultaneously non- "-1" elements, and then the soft bit information blocks to be decoded corresponding to not simultaneously non-"-1" elements between the two columns are stored in the same storage unit.

Each storage unit may group the soft bit information blocks to be decoded and then store them. In an optional embodiment, receiving by the storage unit, the corresponding soft bit information blocks to be decoded and storing them in groups, may include dividing the soft bit information blocks to be decoded into Z soft bit information to be decoded, grouping the Z soft bit information to be decoded according to a preset amount of decoding parallelism P in each group, and storing the Z soft bit information in the storage unit. Z is an extension factor of the basic matrix and Z is a positive integer.

That is to say, each soft bit information block to be decoded is divided into Z soft bit information to be decoded, and then each soft bit information block to be decoded may be divided into Z/P group according to each group of P and stored in the storage unit.

The decoding parallelism P above is the number of computing units in the decoder.

To realize the computations of respective computing unit, in an optional embodiment, by the positive shift unit, the performing of positive cyclic shift on the soft bit information to be decoded to obtain the shifted soft bit information to be decoded, includes determining a shift value of the corresponding storage unit according to an element value in the $k^{th}$ row of the basic matrix, and performing positive cyclic shift on the received soft bit information to be decoded according to the shift value to obtain the shifted soft bit information to be decoded.

The determination of the shift value of the corresponding storage unit by the element value in the $k^{th}$ row above may be realized through a preset algorithm equation, allowing the shift value of each storage unit to be flexibly set. The positive shift unit performs positive cyclic shift on the received soft bit information to be decoded of the corresponding storage unit according to the shift value of the corresponding storage unit, and then outputs the shifted soft bit information to at least one computing unit according to a preset routing mode, thereby to permutate the soft bit information output by each shift unit to the corresponding check node for computing.

After the soft bit information to be decoded of the variable node n in the basic matrix of the LDPC code is obtained, since the iterative method is used in computation in the embodiments of the present disclosure, the computing unit firstly determines whether the amount of decoding iterations i of the LDPC code is less than a preset decoding iteration threshold, if i is less than the preset decoding iteration threshold , the iterations have not been completed, and if i is equal to the preset decoding iteration threshold, the iterations are completed.

If the computing unit determines that the amount of decoding iterations i is less than the preset decoding iteration threshold, the iterations have not been completed, and since the decoding is performed by layers in the embodiments, the determination of whether the amount of decoding layers k of the LDPC code is less than the amount of rows a of the basic matrix is also required.

When it is determined that the amount of decoding layers k is determined less than the amount of rows a of the basic matrix, the computing unit determines the soft bit information of the variable node n in the kth layer of the basic matrix according to soft bit information of the variable node n in the (k-1)th layer of the basic matrix, and determines the variable node information from the variable node n to the check node m in the (k+1)th layer of the basic matrix according to the soft bit information of the variable node n in the (k-1)th layer of the basic matrix. Specifically, if it is determined that the amount of decoding layers k is less than the amount of rows a of the basic matrix, it means that the decoding has not been completed. In a specific implementation process, when the soft bit information of variable node n in the kth layer of the basic matrix is determined, the variable node information from the variable node n to the check node m in the (k+1)th layer of the basic matrix may be determined according to the known soft bit information of the variable node n in the (k-1)th layer of the basic matrix at the same time.

In an optional embodiment, when determined by the computing unit that the amount of decoding layers k is less than the amount of rows a of the basic matrix, determining the soft bit information of the variable node n in the kth layer of the basic matrix according to the soft bit information of the variable node n in the (k-1)th layer of the basic matrix, and determining the variable node information from the variable node n to the check node m in the (k+1)th layer of the basic matrix, may include: subtracting check node information from the variable node n to the check node m in last iteration from the soft bit information of the variable node n in the (k-1)th layer of the basic matrix and adding check node information from the variable node n to the check node m in the kth layer of the basic matrix, to obtain a value, and the value obtained is determined as the soft bit information of the variable node n in the kth layer of the basic matrix.

Specifically, the soft bit information of the variable node n in the kth layer of the basic matrix may be computed by the following equation:

$$Q_n^k = Q_n^{k-1} - R_{mn}^{old,k} + R_{mn}^{new,k} \qquad (1)$$

where $Q_n^k$ represents the soft bit information of the variable node n in the kth layer, $Q_n^{k-1}$ represents the soft bit information of the variable node n in the (k-1)th layer, $R_{mn}^{old,k}$ represents the check node information from the variable node n to the check node m in the kth layer of the basic matrix in the last iteration, and $R_{mn}^{new,k}$ represents the check node information from the variable node n to the check node m in the kth layer of the basic matrix, and where, $n \in N(m)$

The variable node information from the variable node n to the check node m in the (k+1)th layer of the basic matrix may be computed by the following equation:

$$Q_{mn}^{k+1} = Q_n^{k-1} - R_{mn}^{old,k+1} \qquad (2)$$

where $Q_{mn}^{k+1}$ represents the variable node information from the variable node n to the check node m in the (k+1)th layer of the basic matrix, $Q_n^{k-1}$ represents the soft bit information of the variable node n in the (k-1)th layer of the basic matrix, and $R_{mn}^{old,k+1}$ represents the check node information from the variable node n to the check node m in the (k+1)th layer of the basic matrix in the last iteration.

In determining the check node information from the check node m to variable node n in the (k+1)th layer of the basic matrix according to the variable node information from the variable node n to the check node m in the (k+1)th layer of the basic matrix, after the variable node information from the variable node n to the check node m in the (k+1)th layer is obtained by calculating, the check node information from the check node m to the variable node n in the (k+1)th layer of the basic matrix may be calculated by the following equation:

$$R_{mn}^{new,k+1} = f(Q_{mj}^{k+1}) \qquad (3)$$

where $R_{mn}^{new,k+1}$ represents the check node information from the check node m to the variable node n in the (k+1)th layer of the basic matrix, and the function f may adopt one of min-sum (MS) algorithm, normalized min-sum (NMS) algorithm and offset min-sum(OMS) algorithm, and the input information $Q_{mj}^{k+1}$ of the function f is information of all variable nodes connected to the check node m in the (k+1)$^{th}$ layer except variable node n, and where $j \in N(m)$, j ≠ n.

The computing unit updates the amount of decoding layers k to k+1, and re-determines whether the amount of decoding layers k of the LDPC code is less than the amount of rows a of the basic matrix; updates the amount of decoding iterations i to i+1 when it is determined that the amount of decoding layers k is determined greater than or equal to the amount of rows a of the basic matrix, re-determines whether the amount of decoding iterations i of the LDPC code is less than the preset decoding iteration threshold.

The computing unit updates the amount of decoding layers k to k+1 after the decoding of the k$^{th}$ layer is completed, and returns to determine whether the amount of decoding layers k of the LDPC code is less than the amount of rows a of the basic matrix. If k is greater than or equal to the amount of rows a of the basic matrix, The computing unit completes this iteration, updates the amount of decoding iterations i to i+1, and returns to execute S102, until the amount of decoding iterations i is equal to the preset decoding iteration threshold.

The computing unit determines the soft bit information of the variable node n in the k$^{th}$ layer as a decoding result of the soft bit information to be decoded of the variable node n when the amount of decoding iterations i is equal to the preset decoding iteration threshold.

Here, when the amount of decoding iterations i is equal to the preset decoding iteration threshold, it means that the whole iteration process is completed, and the iteration result is recorded as the decoding result, that is, the soft bit information of the variable node n in the k$^{th}$ layer is determined as the decoding result of the soft bit information to be decoded of the variable node n.

Where, k has an initial value of 0, and when k=0, 1 or 2, the variable node information from the variable node n to the check node m in the k-2$^{th}$ layer is the soft bit information to be decoded of the variable node n.

In addition, after the computing unit completes decoding and obtains the soft bit information of the variable node n, the soft bit information of the variable node n is stored. In an optional embodiment, the decoder further includes at least one inverse shift unit, and the at least one inverse shift unit corresponds to the storage unit in an one to one manner. After the amount of decoding iterations i is equal to the preset decoding iteration threshold, the method further includes receiving by the routing unit, the decoding result from at least one computing unit, and outputting the decoding result to at least one inverse shift unit according to a preset routing mode; determining by the flow line control unit, that the inverse shift unit receives the decoding result, triggering the inverse shift unit, and by the inverse shift unit, inversely cyclic shifting and outputting the decoding result to the corresponding storage unit according to a shift value.

The shift value of each storage unit may be flexibly set, and the inverse shift unit performs inverse cyclic shift on the received soft bit information of the variable node n according to the shift value of the corresponding storage unit and outputs it to the corresponding storage unit for storage.

Examples will be given below to illustrate the decoder in one or more of the above embodiments.

Fig. 2 is a schematic diagram of an optional structure of a computing unit in an embodiment of the present disclosure. As shown in Fig. 2, the computing unit is configured to complete the computing of variable node information of one check row, the computing of check node information, the storage of check node information and the update computing of soft bit information of variable node. P computing units complete the parallel computing of P check rows in parallel. Each computing unit includes VNU, CNU (check node computing unit), UPD and CRAM (Check Random-Access storage).

VNU is configured to complete the computing of variable node information. Each VNU simultaneously receives check node information of all variable nodes connected to the check node output by CRAM, and completes the computing of all variable node information connected to the check node at the same time, that is, the variable node information of the same check row is calculated in full parallel.

CNU is configured to complete the computing of check node information. Each CNU simultaneously receives variable node information output by VNU, and completes the computing of check node information from the check node to all variable nodes connected thereto, that is, all check node information of the same check row is calculated in full parallel. CNU outputs the calculated check node information to CRAM for update storing and to UPD for update computing.

CRAM is configured to update and store the check node information. CRAM outputs the check node information obtained from the last iteration computing for VNU to complete the computing of variable node information, and receives the check node information output by CNU in the current iteration process and updates and stores it.

UPD is configured to complete the update computing of soft bit information of variable node. UPD receives new check node information output by CNU, reads old check node information from CRAM, and completes the update computing of soft bit information of all variable nodes in the check row in full parallel.

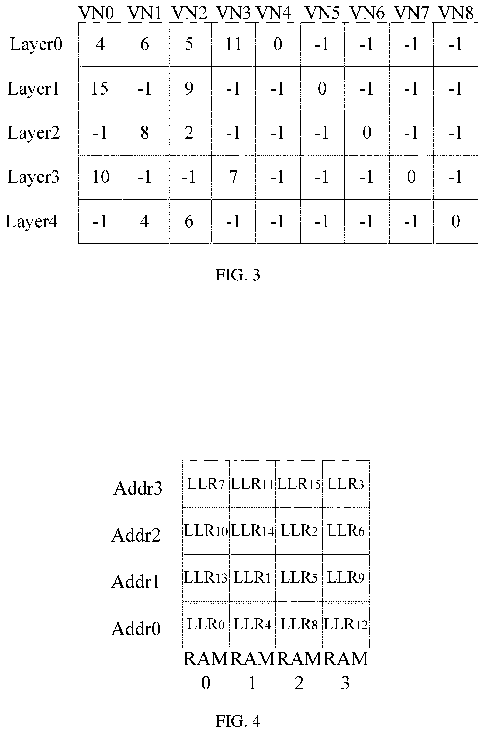

Based on the above decoder, Fig. 3 is an optional layout diagram of a basic matrix in an embodiment of the present disclosure. The basic matrix H in this example is as shown in Fig. 3. The basic matrix is $H(5 \times 9)$, with an extension factor Z=16, that is, the basic matrix H is composed of $5 \times 9$ of $16 \times 16$ cyclic shift submatrices, non-"-1" elements in the matrix represent the shift values of the cyclic shift submatrices, and the submatrices at the position of "- 1" elements are zero matrix. The basic matrix includes five layers, namely layer0, layer1, layer2, layer3 and layer4, with 16 check rows in each layer. The 16 check rows in each layer adopt a partial parallel computing method, and the partial parallelism P adopted in this example is P=4. No specific restriction is made on the partial parallelism P in the embodiments of the present disclosure. The 16 check nodes c0~c12 in each layer are divided into Z/P=4 groups: the first group includes c0, c4, c8, c12; the second group includes c1, c5, c9 and c13; the third group includes c2, c6, c10 and c14; the fourth group includes c3, c7, c11 and c15. Four check nodes in each group are processed in parallel, and each group is processed in series.

Fig. 4 is a schematic diagram of an optional storage format of a storage unit in an embodiment of the present disclosure. As shown in Fig. 4, a corresponding storage format conversion is performed on each soft bit information block according to the parallelism P and the extension factor Z. In an example, 16 soft bit information of each soft bit information block, LLR0-LLR15, are divided into 4 groups, and each group is stored at the addresses Addr0, Addr1, Addr2 and Addr3 of RAM0, RAM1, RAM2 and RAM3, respectively, where the first group includes LLR0, LLR4, LLR8 and LLR12; the second group includes LLR1, LLR5, LLR9 and LLR13; the third group includes LLR2, LLR6, LLR10 and LLR14; the fourth group includes LLR3, LLR7, LLR11 and LLR15.

To write the soft bit information blocks, input in series or parallel, into RAM0~3 at a faster speed, each group of soft bit information may be stored in a "spiral" mode, and the write address of each soft bit information may be obtained by "look-up table" or computed. In an example, the code word to be decoded contains 9 soft bit information blocks. The soft bit information storage unit receives the soft bit information blocks output by the format conversion unit, and stores each soft bit information block in the storage unit individually or jointly according to the orthogonality of columns of the basic matrix H.

In this example, the columns corresponding to variable nodes VN0, VN1, VN2 and VN3 of the basic matrix H are not orthogonal to each other, and the corresponding soft bit information blocks are stored in different storage units respectively, while the columns corresponding to variable nodes VN4, VN5, VN6, VN7 and VN8 are orthogonal to each other, and the corresponding soft bit information blocks are stored in the same storage unit together.

Herein, the orthogonality of columns means that any two columns are non- "-1" elements at the same position.

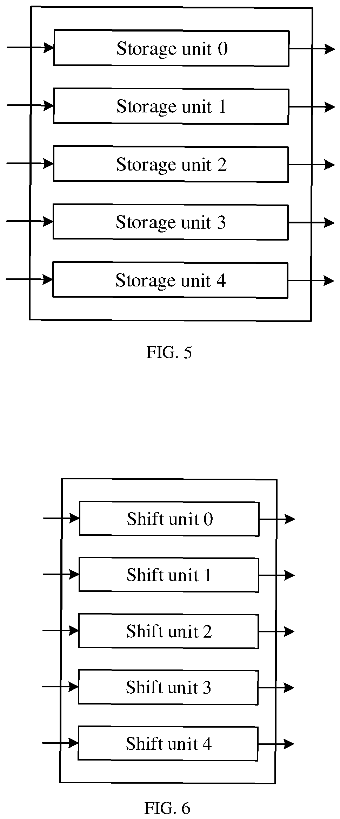

Fig. 5 is a schematic diagram of an optional structure of a storage unit in an embodiment of the present disclosure. As shown in Fig. 5, the storage bit width of each storage unit is equal to 4 times of the soft bit information bit width, where storage unit 0 stores the soft bit information block of the variable node VN0; storage unit 1 stores the soft bit information block of the variable node VN1; storage unit 2 stores the soft bit information block of the variable node VN2; storage unit 3 stores the soft bit information block of the variable node VN3; storage unit 4 stores the soft bit information blocks of variable nodes VN4, VN5, VN6, VN7 and VN8, and the starting storage addresses of each soft bit information block are Addr0, Addr4, Addr8, Addr12 and Addr16, respectively. Since a common storage unit is used for the variable node information with orthogonal columns, this storage way reduces the storage resource consumption of the decoder.

Each storage unit outputs 4 soft bit information stored at one address each time, and 5 storage units output 20 soft bits of information at the same time. It takes a total of Z/P=4 times to complete the computing of 16 checks in one layer in participating in the computing of 4 check rows in parallel.

The first computing of Layer0 corresponds to the first group of check rows c0, c4, c8 and c12, and the initial read address of the storage unit 0 may be obtained according to the following equation:

$$\text{Init\_addr}\,0 = \text{mod}(H_{0,0}, P) \qquad\qquad (4)\,,$$

calculated is Init_addr = mod(4,4) = 0 ; thus the soft bit information {VN0LLR0, VN0LLR4, VN0LLR8, VN0LLR12} stored at address Addr0 is output.

By that analogy:

the storage unit 1 outputs the soft bit information {VN1LLR10, VN1LLR14, VN1LLR2, VN1LLRr6} stored at the address Addr2;
the storage unit 2 outputs the soft bit information {VN2LLR13, VN2LLR1, VN2LLR5, VN2LLR9} stored at the address Addr1;
the storage unit 3 outputs the soft bit information {VN3LLR7, VN3LLR11, VN3LLR15, VN3LLR3} stored at the address Addr3; and
the storage unit 4 outputs the soft bit information {VN4LLR0, VN4LLR4, VN4LLR8, VN4LLR12} stored at the address Addr0.

The information permutation of soft bit information of each check node to the corresponding check row is completed by the positive shift unit and the routing unit. Fig. 6 is a schematic diagram of an optional structure of a shift unit in an embodiment of the present disclosure, as shown in Fig. 6, 5 positive shift units (shift unit 0, shift unit 1, shift unit 2, shift unit 3 and shift unit 4) are included, each of which corresponds to one storage unit, receives 4 soft bit information calculated and output by the storage unit in parallel each time, and completes the cyclic shift operation of the 4 soft bit information according to the preset shift value.

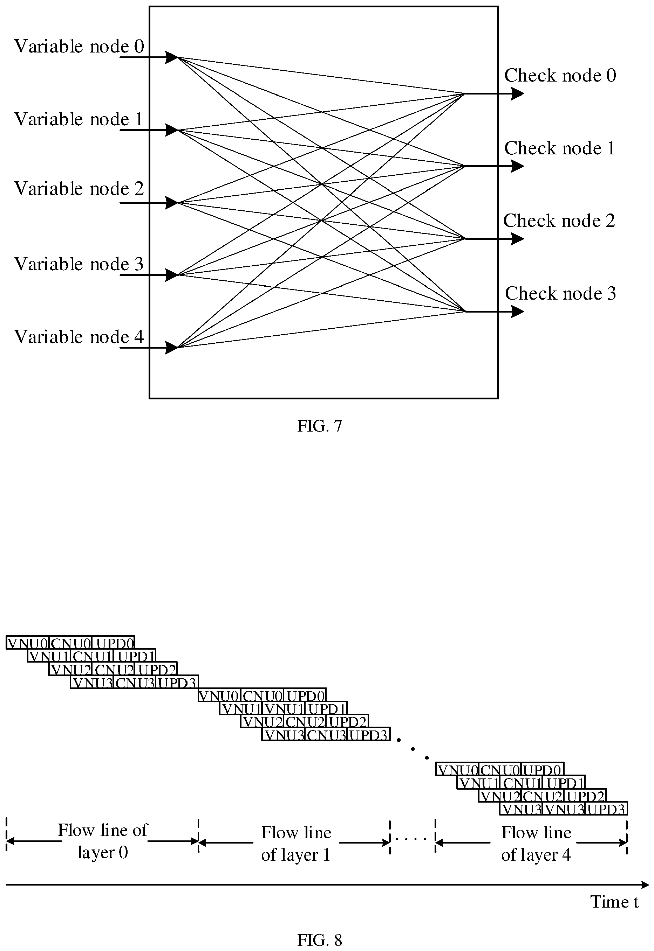

Fig. 7 is an optional structural schematic diagram of a routing unit in an embodiment of the present disclosure. As shown in Fig. 7, the soft bit information output by each positive shift unit is permutated to the corresponding check node for computing by means of fixed connection.

As the common storage units are used for variable node information with orthogonal columns, the number of the storage units is reduced, and as the number of the positive shift units is equal to the number of the storage units, the number of the shift units is reduced accordingly, whereby the hardware resource consumption of shift units as well as the connection complexity of shift networks are greatly reduced.

Specifically, the information permutation of variable nodes and check nodes in the first computing process of Layer0 is as follows:

the soft bit information VN0LLR4, VN1LLR6, VN2LLR5, VN3LLR11 and VN4LLR0 participate in the computing of the check row c0;

the soft bit information VN0LLR8, VN1LLR10, VN2LLR9, VN3LLR15 and VN4LLR4 participate in the computing of the check row c4;

the soft bit information VN0LLR12, VN1LLR14, VN2LLR13, VN3LLR3 and VN4LLR8 participate in the computing of the check row c8; and

the soft bit information VN0LLR0, VN1LLR2, VN2LLR1, VN3LLR7 and VN4LLR12 participate in the computing of the check row c12.

In this way, the reading of the soft bit information and the information permutation between variable nodes and check nodes are completed in a decoding computing process.

By that analogy, the second computing of Layer0 corresponds to the second group of check rows c1, c5, c9 and c13, and the soft bit information is read as follows:

the storage unit 0 outputs soft bit information {VN1LLR13, VN1LLR1, VN1LLR5, VN1LLR9} stored at address Addr1;

the storage unit 1 outputs soft bit information {VN1LLR7, VN1LLR11, VN1LLR15, VN1LLR3} stored at the address Addr3;

the storage unit 2 outputs soft bit information {VN2LLR10, VN2LLR14, VN2LLR2, VN2LLR6} stored at the address Addr2;

the storage unit 3 outputs soft bit information {VN3LLR0, VN3LLR4, VN3LLR8, VN3LLR12} stored at the address Addr0; and

the storage unit 4 outputs soft bit information {VN4LLR13, VN4LLR1, VN4LLR5, VN4LLR9} stored at the address Addr1.

The information permutation of variable nodes and check nodes in the second computing of Layer0 is as follows:

the soft bit information VN0LLR5, VN1LLR7, VN2LLR6, VN3LLR12 and VN4LLR1 participate in the computing of the check row c1;

the soft bit information VN0LLR9, VN1LLR11, VN2LLR10, VN3LLR0 and VN4LLR5 participate in the computing of the check row c5;

the soft bit information VN0LLR13, VN1LLR15, VN2LLR14, VN3LLR4 and VN4LLR9 participate in the computing of the check row c9; and

the soft bit information VN0LLR1, VN1LLR3, VN2LLR2, VN3LLR8 and VN4LLR13 participate in the computing of the check row c13.

The third computing of Layer0 corresponds to the third group of check rows c2, c6, c10 and c14, and the soft bit information is read as follows:

the storage unit 0 outputs soft bit information {VN1LLR10, VN1LLR14, VN1LLR2, VN1LLR6} stored at address Addr2;

the storage unit 1 outputs soft bit information {VN1LLR0, VN1LLR4, VN1LLR8, VN1LLR12} stored at the address Addr0;

the storage unit 2 outputs soft bit information {VN2LLR7, VN2LLR11, VN2LLR15, VN2LLR3} stored at the address Addr3;

the storage unit 3 outputs soft bit information {VN3LLR13, VN3LLR1, VN3LLR5, VN3LLR9} stored at the address Addr1; and

the storage unit 4 outputs soft bit information {VN4LLR10, VN4LLR14, VN4LLR2, VN4LLR6} stored at the address Addr2.

The information permutation of variable nodes and check nodes in the third computing of Layer0 is as follows:

the soft bit information VN0LLR6, VN1LLR8, VN2LLR7, VN3LLR13 and VN4LLR2 participate in the computing of the check row c2;

the soft bit information VN0LLR10, VN1LLR12, VN2LLR11, VN3LLR1 and VN4LLR6 participate in the computing of the check row c6;

the soft bit information VN0LLR14, VN1LLR0, VN2LLR15, VN3LLR5 and VN4LLR10 participate in the computing of the check row c10; and

the soft bit information VN0LLR2, VN1LLR4, VN2LLR3, VN3LLR9 and VN4LLR14 participate in the computing of the check row c14;

The fourth computing of Layer0 corresponds to the third group of check rows c3, c7, c11 and c15, and the soft bit information is read as follows:

the storage unit 0 outputs soft bit information {VN1LLR7, VN1LLR11, VN1LLR15, VN1LLR3} stored at address Addr3;

the storage unit 1 outputs soft bit information {VN1LLR13, VN1LLR1, VN1LLR5, VN1LLR9} stored at the address Addr1;

the storage unit 2 outputs soft bit information {VN2LLR0, VN2LLR4, VN2LLR8, VN2LLR12} stored at the address Addr0;

the storage unit 3 outputs soft bit information {VN3LLR10, VN3LLR14, VN3LLR2, VN3LLR6} stored at the address Addr2; and

the storage unit 4 outputs soft bit information {VN4LLR7, VN4LLR11, VN4LLR15, VN4LLR3} stored at the address Addr3.

The information permutation of variable nodes and check nodes in the fourth computing of Layer0 is as follows:

the soft bit information VN0LLR7, VN1LLR9, VN2LLR8, VN3LLR14 and VN4LLR3 participate in the computing of the check row c3;

the soft bit information VN0LLR11, VN1LLR13, VN2LLR12, VN3LLR2 and VN4LLR7 participate in the computing of the check row c7;

the soft bit information VN0LLR15, VN1LLR1, VN2LLR0, VN3LLR6 and VN4LLR11 participate in the computing of the check row c11; and

the soft bit information VN0LLR3, VN1LLR5, VN2LLR4, VN3LLR10 and VN4LLR15 participate in the computing of the check row c15.

One computing unit completes the computing of one check row. The decoder of this example needs 4 parallel computing units to complete the computing of 4 check rows in parallel each time, and complete the computing of 16 check rows in one layer in four times. Herein, for VNU, CNU and UPD in each computing unit, a flow line mode is adopted to complete the computing of all check rows in one layer, and a layered flow line mode is adopted between layers. Fig. 8 is a schematic diagram of an optional flow line of layered-decoding in an embodiment of the present disclosure. As shown in Fig. 8, the computing of the K$^{th}$ layer is based on the computing results of the (K-1)$^{th}$ layer, and the data of the 4 check rows calculated of the first time in each layer are first input to their corresponding computing units in parallel for computing, a first VNU computing process is recorded as VNU0, a first CNU computing process is recorded as CNU0, a first UPD computing process is recorded as UPD0. By that analogy, when the VNU4 process, CNU4 process and UPD4 process of the fourth computing are all completed, the flow line computing of this layer is finished and the flow line of the next layer is started.

The layered flow line mode can ensure that the computing of each layer is based on the latest results of the previous layer, that is a standard layered-decoding method. In the process of flow line computing between layers, VNU, CNU and UPD computing units have long idle time of flow line, resulting in the decrease of flow line efficiency. Specifically, the computing delay of one VNU flow line is $T_{vnu}$, the computing delay of one CNU flow line is $T_{cnu}$, the computing delay of one UPD flow line is $T_{upd}$, and the interval time of each computing in a single layer is unit time 1. Then, in this example, a total of 5 layers of flow lines are required for one iteration, and the decoding delay of one iteration is:

$$T_{iter} = (T_{vnu} + T_{cnu} + T_{upd} + 4) \times 5 \qquad (5)$$

The flow line control unit outputs enable signals, to control the flow line process in which the positive shift unit to read soft bit information from the storage unit for shift permutation, control the flow line process in which the VNU computing unit to calculate variable node information, control the flow line process in which the CNU computing unit to calculate check node information, control the flow line process in which the UPD computing unit to update soft bit information, and control the flow line process in which the inverse shift unit to perform shift permutation for new soft bit information and update the storage unit.

In this example, the decoder adopts the layered flow line mode to realize the standard layered-decoding process of QC-LDPC codes. The parallelism of the whole decoder is 4, that is, 4 computing units are required to complete the parallel computing of 4 check rows at the same time. The storage unit is shared for the soft bit information of variable node with orthogonal columns, to reduce the number of storage units from 9 to 5 and the number of positive/inverse shift units from 9 to 5 at the same time. Because the number of shift units is reduced, the complexity of the routing unit between the shift unit and the computing unit is also greatly reduced. Therefore, the storage resource consumption and hardware implementation complexity of the decoder can be reduced by adopting the storage mode of the decoder in the embodiment of the present disclosure. In addition, the decoder in the embodiment of the present disclosure adopts a partial parallel decoding mode with a fixed parallelism P, and stores the soft bit information block in a "spiral" mode, so that QC-LDPC codes with different extension factors Z can be decoded without increasing the complexity of the decoder, offering higher decoding flexibility.

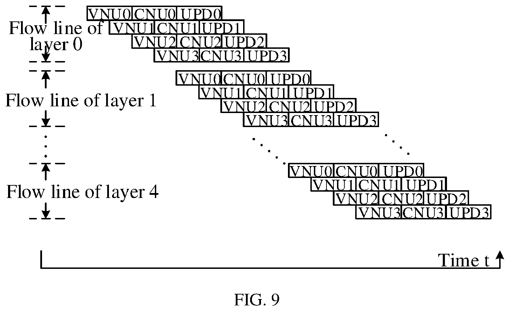

Fig. 9 is a schematic diagram of an optional flow line of layer overlapped-decoding in an embodiment of the present disclosure, and this decoding method may also be applied to the above decoder. In this embodiment, the same basic matrix H, the same extension factor Z and the same parallelism P as those in the above layered-decoding method are adopted, so this embodiment differs from the layered-decoding method only in decoding mode. The decoder of the embodiment adopts a fast layered-decoding mode, for simplicity, only the differences between the two are described.

One computing unit completes the computing of one check row. The decoder of this example needs 4 parallel computing units to complete the computing of 4 check rows in parallel each time, and complete the computing of 16 check rows in one layer in 4 times. For VNU, CNU and UPD in each computing unit, a flow line mode is adopted to complete the computing of all check rows in one layer, and an overlapped flow line mode is adopted between layers. The schematic diagram of layer overlapped flow line is shown in Fig. 9.

According to the fast layered-decoding method, there is no dependency between the computing of two adjacent layers, that is, VNU computing, CNU computing and UPD computing of the k$^{th}$ layer all depend on the computing results of the soft bit information in the k-2$^{th}$ layer, so it is not necessary to wait for the last UPD flow line computing of the (k-1)$^{th}$ layer to be completed, and the VNU flow line computing of the k$^{th}$ layer may be started in advance. In an example, the VNU0 flow line computing of the 1$^{st}$ layer may be started immediately after the VNU3 flow line computing of the 0$^{th}$ layer is started. Similarly, the VNU0 flow line computing in the 2$^{nd}$ layer can be started immediately after the VNU3 flow line computing in the 1$^{st}$ layer is started. By that analogy, the VNU0 flow line computing in the 4$^{th}$ layer can be started immediately after the VNU3 flow line computing in the 3rd layer is started. The current iteration computing is completed until the UPD3 flow line computing in the 4th layer is completed.

By adopting the layer overlapped flow line mode, the flow line computing between layers is continuously carried out, ensuring no idle waiting time in the whole iteration computing process for VNU, CNU and UPD computing units, and thereby offering higher flow line efficiency. If one VNU flow line has a computing delay of $T_{vnu}$, one CNU flow line has a computing delay of $T_{cnu}$, one UPD flow line has a computing delay of $T_{upd}$, and the interval time of each computing for a single layer is unit time 1, in this example, a total of 5 layers with 4 flow lines per layer are required for one iteration, and the decoding delay of one iteration is.

$$T_{iter} = \mathrm{T}_{vnu} + \mathrm{T}_{cnu} + \mathrm{T}_{upd} + 4 \times 5 \qquad (6)$$

The flow line control unit outputs enable signals, to control the flow line process in which the positive shift unit to read soft bit information from the storage unit for shift permutation, control the flow line process in which the VNU computing unit to calculate variable node information, control the flow line process in which the CNU computing unit to calculate check node information, control the flow line process in which the UPD computing unit to update soft bit information, and control the flow line process in which the inverse shift unit to perform shift permutation for the new soft bit information and update the soft bit information storage unit. The flow line control unit is configured to complete the flow line control in the decoding iteration process, by adopting the layered flow line in the standard layered-decoding mode and adopting the layer overlapped flow line in the fast layered- decoding mode, that is, to realize a switching function of flow line mode by generating the enable signals at all levels of the flow line.

In the embodiment the decoder adopts the layer overlapped flow line mode to realize a fast layered-decoding process of QC-LDPC codes. The parallelism of the whole decoder is 4, that is, 4 computing units are required to complete the parallel computing of 4 check rows at the same time. The storage unit is shared for the variable node soft bit information with orthogonal columns, reducing the number of storage units from 9 to 5 and the number of positive/inverse shift units from 9 to 5 at the same time. Because the number of shift units is reduced, the complexity of the routing unit between the shift unit and the computing unit is also greatly reduced. The storage resource consumption and hardware implementation complexity of the decoder can be reduced by the adoption of the storage mode of the decoder in the embodiment of the present disclosure. In addition, the decoder in the embodiment of the present disclosure adopts a partial parallel decoding mode with a fixed parallelism P, and stores the soft bit information block in a "spiral" mode, so that QC-LDPC codes with different extension factors Z can be decoded without increasing the complexity of the decoder and with higher decoding flexibility.

The decoder provided by the embodiments of the present disclosure includes at least one computing unit, which is configured to: acquire soft bit information to be decoded of a variable node n in a basic matrix of a LDPC code, and determine whether the amount of decoding iterations i of the LDPC code is less than a preset amount of decoding iterations; if the amount of decoding iterations i of the LDPC code is less than the preset amount of decoding iterations, determine whether the amount of decoding layers k of the LDPC code is less than the amount of rows a of the basic matrix; if the amount of decoding layers k of the LDPC code is less than the amount of rows a of the basic matrix, determine soft bit information of a variable node n in a kth layer of the basic matrix according to soft bit information of a variable node n in a (k-1)th layer of the basic matrix, and determine variable node information from a variable node n to a check node m in a (k+1)th layer of the basic matrix according to the soft bit information of the variable node n in the (k-1)th layer of the basic matrix; and determine check node information from the check node m to the variable node n in the (k+1)th layer of the basic matrix according to the variable node information from the variable node n to the check node m in the (k+1)th layer of the basic matrix. In this way, the variable node information in the next layer is generated while the soft bit information of the variable node n in the kth layer is obtained, and in turn the check node information in the next layer is generated. Compared with existing technologies, according the embodiments of the present disclosure, the variable node information and the check node information of the next layer are generated in advance, preparing for the generation of the soft bit information of the variable node n in the next layer, whereby the decoding speed is speeded up. While the soft bit information of the variable node n in the kth layer is obtained, k is updated to k+1, and the decoding of next layer is performed until the decoding in a layers is completed, the amount of decoding iterations i is updated to i+1, and the iterations are performed until the iteration times are equal to the preset number of iterations, thus the soft bit information is obtained. That is to say, in an embodiment, when the soft bit information of the variable node n in the kth layer of the basic matrix is generated, it is started to generate the variable node information of the next layer, and in turn to generate the check node information of the next layer. On this basis, when the decoding is performed in the (k+1)th layer, the soft bit information of the variable node n in the (k+1)th layer of the basic matrix can be determined directly according to the soft bit information of the variable node n in the kth layer. Compared with existing technologies, the computing of the variable node information in the (k+1)th layer and the check node information in the (k+1)th layer can be started without waiting for the soft bit information of the variable node n in the kth layer to be generated, thus speeding up the decoding speed and improving the decoding efficiency of LDPC decoder.

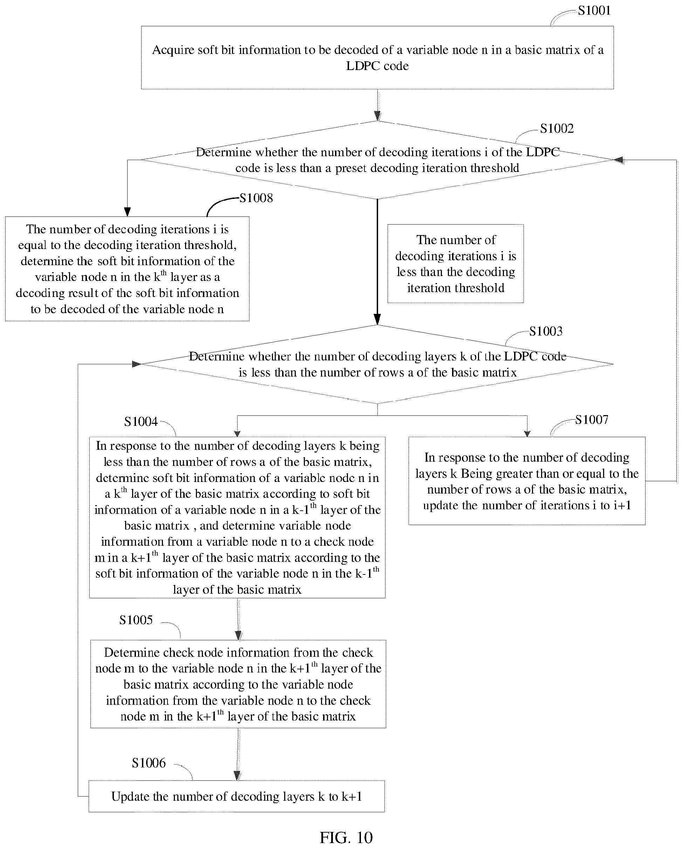

Based on the same inventive concept, a decoding method is further provided according to an embodiment of the present disclosure. Fig. 10 is a schematic flowchart of the decoding method in the embodiment of the present disclosure. As shown in Fig. 10, the method is applied to at least one computing unit of a decoder, and may include following steps S1001-S1008.

At S1001: soft bit information to be decoded of a variable node n in a basic matrix of a LDPC code is acquired.

At S1002: whether an amount of decoding iterations i of the LDPC code is less than a preset decoding iteration threshold is determined.

At S1003: in response to the amount of decoding iterations i being less than the preset decoding iteration threshold, whether an amount of decoding layers k of the LDPC code is less than an amount of rows a of the basic matrix is determined.

At S1004: in response to the amount of decoding layers k of the LDPC code being less than the amount of rows a of the basic matrix, soft bit information of a variable node n in a $k^{th}$ layer of the basic matrix is determined according to soft bit information of a variable node n in a $(k-1)^{th}$ layer of the basic matrix, and variable node information from a variable node n to a check node m in a $(k+1)^{th}$ layer of the basic matrix is determined according to the soft bit information of the variable node n in the $(k-1)^{th}$ layer of the basic matrix.

At S1005: check node information from the check node m to the variable node n in the $(k+1)^{th}$ layer of the basic matrix is determined according to the variable node information from the variable node n to the check node m in the $(k+1)^{th}$ layer of the basic matrix.

At S1006: the amount of decoding layers k is updated to k+1, and whether the amount of decoding layers k of the LDPC code is less than the amount of rows a of the basic matrix re-determined.

At S1007: in response to the amount of decoding layers k being greater than or equal to the amount of rows a of the basic matrix, the amount of decoding iterations i is updated to i+1, and whether the amount of decoding iterations i of the LDPC code is less than the preset decoding iteration threshold is re-determined.

At S1008: in response to the amount of decoding iterations i being equal to the preset decoding iteration threshold, the soft bit information of the variable node n in the $k^{th}$ layer is determined as a decoding result of the soft bit information to be decoded of the variable node n.

Where, when i has an initial value of 0, k has an initial value of 0, and when k=0 or 1, the soft bit information of the variable node n in the $(k-1)^{th}$ layer is the soft bit information to be decoded of the variable node n; and where n is an integer greater than or equal to 0 and less than an amount of columns b of the basic matrix.

In an optional embodiment, by the computing unit, the step of determining the variable node information from the variable node n to the check node m in the $(k+1)^{th}$ layer of the basic matrix according to the soft bit information of the variable node n in the $(k-1)^{th}$ layer of the basic matrix includes subtracting check node information from the variable node n to the check node m in the $k^{th}$ layer of the basic matrix in the last iteration from the soft bit information of the variable node n in the $(k-1)^{th}$ layer of the basic matrix, and adding check node information from the variable node n to the check node m in the $k^{th}$ layer of the basic matrix, to obtain a value determined as the soft bit information of the variable node n in the $k^{th}$ layer of the basic matrix.

In an optional embodiment, by the computing unit, the step of determining the variable node information from the variable node n to the check node m in the $(k+1)^{th}$ layer of the basic matrix according to the soft bit information of the variable node n in the $(k-1)^{th}$ layer of the basic matrix includes subtracting check node information from the variable node n to the check node m in the $(k+1)^{th}$ layer of the basic matrix in the last iteration from the soft bit information of the variable node n in the $(k-1)^{th}$ layer of the basic matrix, to obtain a difference value, and determining the difference value obtained as the variable node information from the variable node n to the check node m in the (k+1)th layer of the basic matrix.

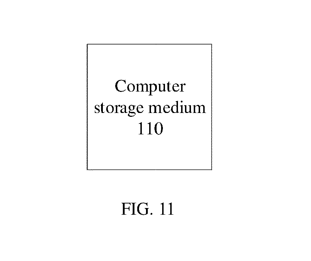

Based on the foregoing embodiments, a computer storage medium is further provided according to an embodiment of the present disclosure. Fig. 11 is a schematic structural diagram of the computer storage medium of embodiment of this application. As shown in Fig. 11, the computer storage medium 110 has a computer program stored thereon that, when executed by a processor, causes the processor to perform the steps of the decoding method according to one or more of the embodiments described above.

It should be noted that, in the present disclosure, the terms "comprise", "include" or any variants thereof are intended to cover non-exclusive inclusions, so that a process, method, article or device including a series of elements not only includes those elements, but also includes other elements not explicitly listed, or elements inherent to the process, method, article, or device. In the case of no further restriction, the element defined by the sentence "including a..." does not exclude the existence of other identical elements in the process, method, article or device that includes the element.

The numbers of the foregoing embodiments of the present disclosure are only for description, the embodiments are in and of themselves, neither good nor bad.

Through the description of the above embodiments, those skilled in the art can clearly understand that the method of the above embodiments can be implemented by means of software plus the necessary general hardware platform. Of course, it can also be implemented by hardware, but in many cases the former is better. Based on this understanding, the technical solution of this application essentially or the part that contributes to the related technology can be embodied in the form of a software product, the computer software product is stored in a storage medium (such as ROM/RAM, magnetic disk, optical disk)) Includes several instructions to make a terminal (which can be a mobile phone, a computer, a server, an air conditioner, or a network device, etc.) execute the method described in each embodiment of the application.

The embodiments of the present disclosure are described in detail above with reference to the accompanying drawings, but the present disclosure is not limited to the above-described embodiments. The above-mentioned embodiments are merely illustrative and nonrestrictive. In light of the present disclosure, those of ordinary skill in the art can make various modifications without departing from the scope of the disclosure, and these modifications all fall within the protection scope of the appended claims.

**Claims**

1. A decoder, comprising at least one computing unit, **characterized in that** the computing unit is configured to:

    acquire soft bit information to be decoded of a variable node n in a layer of a basic matrix of a low-density parity-check, LDPC, code (S1001), wherein n is an integer greater than or equal to 0 and less than an amount of columns b of the basic matrix;
    determine whether an amount of decoding iterations i of the LDPC code is less than a preset decoding iteration threshold (S1002);
    in response to the amount of decoding iterations i being determined less than the preset decoding iteration threshold, determine whether an amount of decoding layers k of the LDPC code is less than an amount of rows a of the basic matrix (S1003);
    in response to the amount of decoding layers k of the LDPC code being less than the amount of rows a of the basic matrix, determine soft bit information of a variable node n in a $k^{th}$ layer of the basic matrix according to the soft bit information of a variable node n in a $(k-1)^{th}$ layer of the basic matrix, a check node information from a variable node n to a check node m in a $k^{th}$ layer of the basic matrix in a decoding iteration $(i-1)^{th}$ and a check node information from the variable node n to the check node m in the $k^{th}$ layer of the basic matrix, and determine variable node information from a variable node n to a check node m in a $(k+1)^{th}$ layer of the basic matrix according to the soft bit information of the variable node n in the $(k-1)^{th}$ layer of the basic matrix and a check node information from a variable node n to a check node m in a $(k+1)^{th}$ layer of the basic matrix in the decoding iteration $(i-1)^{th}$ (S1004);
    determine check node information from the check node m to the variable node n in the $(k+1)^{th}$ layer of the basic matrix according to variable node information of all variable nodes connected to the check node m in the $(k+1)^{th}$ layer except the variable node n (S1005);
    update the amount of decoding layers k to k+1 (S1006), and re-determine whether the amount of decoding layers k of the LDPC code is less than the amount of rows a of the basic matrix; and
    in response to the amount of decoding layers k being greater than or equal to the amount of rows a of the basic matrix, update the amount of decoding iterations i to i+1 (S1007), and re-determine whether the amount of decoding iterations i of the LDPC code is less than the preset decoding iteration threshold, until the amount of decoding iterations i is equal to the preset decoding iteration threshold, determine the soft bit information of the variable node n in the $k^{th}$ layer as a decoding result of the soft bit information to be decoded of the variable node n in the basic matrix (S1008);
    wherein, when i has an initial value of 0, k has an initial value of 0, and, when k=0 or 1, the soft bit information of the variable node n in the $k-1^{th}$ layer is the soft bit information to be decoded of the variable node n in the basic matrix.

2. The decoder of claim 1, wherein in determining the variable node information from the variable node n to the check node m in the $(k+1)^{th}$ layer of the basic matrix according to the soft bit information of the variable node n in the $(k-1)^{th}$ layer of the basic matrix, the computing unit is configured to:
    subtracting check node information from the variable node n to the check node m in the $k^{th}$ layer of the basic matrix in the last iteration from the soft bit information of the variable node n in the $(k-1)^{th}$ layer of the basic matrix, and adding check node information from the variable node n to the check node m in the $k^{th}$ layer of the basic matrix, to obtain a value determined as the soft bit information of the variable node n in the $k^{th}$ layer of the basic matrix.

3.  The decoder of claim 1, wherein in determining the variable node information from the variable node n to the check node m in the $(k+1)^{th}$ layer of the basic matrix according to the soft bit information of the variable node n in the $(k-1)^{th}$ layer of the basic matrix, the computing unit is configured to:
    subtract check node information from the variable node n to the check node m in the $(k+1)^{th}$ layer of the basic matrix in a last iteration from the soft bit information of the variable node n in the $(k-1)^{th}$ layer of the basic matrix, and determine a difference value obtained as the variable node information from the variable node n to the check node m in the $(k+1)^{th}$ layer of the basic matrix.

4.  The decoder of claim 1, further comprising a preprocessing unit connected to the computing unit, and before the computing unit acquires the soft bit information to be decoded of the variable node n, the preprocessing unit is configured to:

    acquire the soft bit information to be decoded; and
    preprocess the soft bit information to be decoded to obtain the soft bit information to be decoded of the variable node n.

5.  The decoder of claim 4, wherein, the preprocessing unit comprises a format conversion unit, a routing unit, a flow line control unit, at least one positive shift unit and at least one storage unit; wherein, the format conversion unit is connected to the at least one storage unit, the at least one storage unit is connected to the at least one positive shift unit, the at least one positive shift unit is connected to the routing unit, the routing unit is connected to the at least one computing unit, the flow line control unit is connected to the at least one positive shift unit and the at least one computing unit respectively, and the positive shift unit corresponds to the storage unit one to one;

    the format conversion unit is configured to perform block division on the soft bit information to be decoded to obtain at least one soft bit information block to be decoded, and send the at least one soft bit information block to be decoded to a corresponding storage unit for storage;
    the storage unit is configured to receive and store in groups the soft bit information block to be decoded;
    the flow line control unit is configured to determine that the positive shift unit receives the soft bit information to be decoded and trigger the positive shift unit, and the positive shift unit is configured to perform positive cyclic shift on the soft bit information to be decoded to obtain shifted soft bit information to be decoded; and
    the routing unit is configured to output the shifted soft bit information to be decoded to the at least one computing unit according to a preset routing mode, so that the computing unit acquires the soft bit information to be decoded of the variable node n.

6.  The decoder of claim 5, wherein in performing block division for the soft bit information to be decoded to obtain at least one soft bit information to be decoded, and sends the at least one soft bit information block to the corresponding storage unit for storage, the format conversion unit is configured to:

    divide the soft bit information to be decoded into b soft bit information blocks to be decoded according to the amount of columns b of the basic matrix; wherein each soft bit information block to be decoded corresponds to an element value of the $n^{th}$ column of the basic matrix; and
    store the soft bit information blocks to be decoded corresponding to columns with orthogonality in the basic matrix in the same storage unit from the b soft bit information blocks to be decoded.

7.  The decoder of claim 5, wherein in receiving and storing in groups the soft bit information blocks to be decoded, the storage unit is configured to:

    divide the soft bit information blocks to be decoded into Z soft bit information to be decoded, group the Z soft bit information to be decoded according to a preset amount of decoding parallelism P in each group, and store the Z soft bit information in the storage unit;
    wherein, Z is an extension factor of the basic matrix and a positive integer.

8.  The decoder of claim 5, wherein, in performing positive cyclic shift for the soft bit information to be decoded to obtain the shifted soft bit information to be decoded, the positive shift unit is configured to:

    determine a corresponding shift value according to an element value in the $k^{th}$ row of the basic matrix; and
    perform positive cyclic shift on the received soft bit information to be decoded according to the shift value to obtain the shifted soft bit information to be decoded.

9. The decoder of claim 5, further comprising at least one inverse shift unit connected to the at least one storage unit, the routing unit and the flow line control unit respectively, and the at least one inverse shift unit corresponds to the at least one storage unit one to one;

the routing unit is configured to: until after the amount of decoding iterations i is equal to the preset decoding iteration threshold, receive the decoding result from the at least one computing unit, and output the decoding result to the at least one inverse shift unit according to the preset routing mode; and

the flow line control unit is configured to determine that the inverse shift unit receives the decoding result and trigger the inverse shift unit, and the inverse shift unit is configured to perform inverse cyclic shift on the decoding result and output the decoding result shifted to the corresponding storage unit according to the shift value of the corresponding storage unit.

10. A decoding method, applied in at least one computing unit of a decoder, **characterized in that** the method comprises:

acquiring soft bit information to be decoded of a variable node n in a layer of a basic matrix of a low-density parity-check, LDPC, code (S1001), wherein n is an integer greater than or equal to 0 and less than an amount of columns b of the basic matrix;

determining whether an amount of decoding iterations i of the LDPC code is less than a preset decoding iteration threshold (S1002);

in response to the amount of decoding iterations i being less than the preset decoding iteration threshold, determining whether an amount of decoding layers k of the LDPC code is less than an amount of rows a of the basic matrix (S1003);

in response to the amount of decoding layers k of the LDPC code being less than the amount of rows a of the basic matrix, determining soft bit information of a variable node n in a $k^{th}$ layer of the basic matrix according to the soft bit information of a variable node n in a $(k-1)^{th}$ layer of the basic matrix, a check node information from a variable node n to a check node m in a $k^{th}$ layer of the basic matrix in a decoding iteration $(i-1)^{th}$ and a check node information from the variable node n to the check node m in the $k^{th}$ layer of the basic matrix, and determining variable node information from a variable node n to a check node m in a $(k+1)^{th}$ layer of the basic matrix according to the soft bit information of the variable node n in the $(k-1)^{th}$ layer of the basic matrix and a check node information from a variable node n to a check node m in a $(k+1)^{th}$ layer of the basic matrix in the decoding iteration $(i-1)^{th}$(S1004);

determining check node information from the check node m to the variable node n in the $(k+1)^{th}$ layer of the basic matrix according to variable node information of all variable nodes connected to the check node m in the $(k+1)^{th}$ layer except the variable node n (S1005);

updating the amount of decoding layers k to k+1 (S 1006), and re-determining whether the amount of decoding layers k of the LDPC code is less than the amount of rows a of the basic matrix; and

in response to the amount of decoding layers k being greater than or equal to the amount of rows a of the basic matrix, updating the amount i of decoding iterations to i+1 (S1007), re-determining whether the amount of decoding iterations i of the LDPC code is less than the preset decoding iteration threshold until the amount of decoding iterations i is equal to the preset decoding iteration threshold, and determining the soft bit information of the variable node n in the $k^{th}$ layer as a decoding result of the soft bit information to be decoded of the variable node n in the basic matrix (S1008);

wherein, when i has an initial value of 0, k has an initial value of 0, and when k=0 or 1, the soft bit information of the variable node n in the $(k-1)^{th}$ layer is the soft bit information to be decoded of the variable node n in the basic matrix.

11. The method of claim 10, wherein, determining the variable node information from the variable node n to the check node m in the $(k+1)^{th}$ layer of the basic matrix according to the soft bit information of the variable node n in the $(k-1)^{th}$ layer of the basic matrix comprises:

subtracting check node information from the variable node n to the check node m in the $k^{th}$ layer of the basic matrix in the last iteration from the soft bit information of the variable node n in the $(k-1)^{th}$ layer of the basic matrix, and adding check node information from the variable node n to the check node m in the $k^{th}$ layer of the basic matrix, to obtain a value determined as the soft bit information of the variable node n in the $k^{th}$ layer of the basic matrix.

12. The decoding method of claim 10, wherein, determining the variable node information from the variable node n to the check node m in the $(k+1)^{th}$ layer of the basic matrix according to the soft bit information of the variable node n in the $(k-1)^{th}$ layer of the basic matrix comprises:

subtract check node information from the variable node n to the check node m in the $(k+1)^{th}$ layer of the basic matrix in a last iteration from the soft bit information of the variable node n in the (k-1)$^{th}$ layer of the basic matrix, and determine a difference value obtained as the variable node information from the variable node n to the check node m in the (k+1)$^{th}$ layer of the basic matrix.

13. A computer storage medium, having a computer program stored thereon comprising instructions which, when executed by a processor, cause the processor to perform the decoding method of any of claims 10 to 12.

**Patentansprüche**

1. Dekodierer, umfassend mindestens eine Recheneinheit, **dadurch gekennzeichnet, dass** die Recheneinheit für folgende Vorgänge ausgelegt ist:

   Erfassen von zu dekodierenden Softbit-Informationen eines variablen Knotens n in einer Schicht einer Basismatrix eines "Low-Density Parity-Check"-, LDPC-, Codes (S1001), wobei n eine ganze Zahl größer oder gleich 0 und kleiner als eine Anzahl von Spalten b der Basismatrix ist;
   Bestimmen, ob eine Anzahl von Dekodieriterationen i des LDPC-Codes kleiner ist als ein voreingestellter Dekodieriterationsschwellenwert (S1002);
   als Reaktion darauf, dass die Anzahl von Dekodieriterationen i kleiner als der voreingestellte Dekodieriterationsschwellenwert bestimmt wird, Bestimmen, ob eine Anzahl von Dekodierschichten k des LDPC-Codes kleiner als eine Anzahl von Zeilen a der Basismatrix ist (S1003);
   als Reaktion darauf, dass die Anzahl von Dekodierschichten k des LDPC-Codes kleiner ist als die Anzahl von Zeilen a der Basismatrix, Bestimmen von Softbit-Informationen eines variablen Knotens n in einer k-ten Schicht der Basismatrix gemäß den Softbit-Informationen eines variablen Knotens n in einer (k-1)-ten Schicht der Basismatrix, einer Prüfknoteninformation von einem variablen Knoten n zu einem Prüfknoten m in einer k-ten Schicht der Basismatrix in einer (i-1)-ten Dekodieriteration und einer Prüfknoteninformation vom variablen Knoten n zum Prüfknoten m in der k-ten Schicht der Basismatrix, und Bestimmen von Variabler-Knoten-Informationen von einem variablen Knoten n zu einem Prüfknoten m in einer (k+1)-ten Schicht der Basismatrix gemäß den Softbit-Informationen des variablen Knotens n in der (k-1)-ten Schicht der Basismatrix und einer Prüfknoteninformation von einem variablen Knoten n zu einem Prüfknoten m in einer (k+1)-ten Schicht der Basismatrix in der (i-1)-ten Dekodieriteration (S1004);
   Bestimmen von Prüfknoteninformationen vom Prüfknoten m zum variablen Knoten n in der (k+1)-ten Schicht der Basismatrix entsprechend Variabler-Knoten-Informationen aller variablen Knoten, die mit dem Prüfknoten m in der (k+1)-ten Schicht verbunden sind, außer dem variablen Knoten n (S1005);
   Aktualisieren der Anzahl von Dekodierschichten k auf k+1 (S1006) und erneutes Bestimmen, ob die Anzahl von Dekodierschichten k des LDPC-Codes kleiner ist als die Anzahl von Zeilen a der Basismatrix; und
   als Reaktion darauf, dass die Anzahl von Dekodierschichten k größer oder gleich der Anzahl von Zeilen a der Basismatrix ist, Aktualisieren der Anzahl von Dekodieriterationen i auf i+1 (S1007) und erneutes Bestimmen, ob die Anzahl von Dekodieriterationen i des LDPC-Codes kleiner als der voreingestellte Dekodieriterationsschwellenwert ist, bis die Anzahl von Dekodieriterationen i gleich dem voreingestellten Dekodieriterationsschwellenwert ist, Bestimmen der Softbit-Informationen des variablen Knotens n in der k-ten Schicht als ein Dekodierergebnis der zu dekodierenden Softbit-Informationen des variablen Knotens n in der Basismatrix (S1008);
   wobei, wenn i einen Anfangswert von 0 hat, k einen Anfangswert von 0 hat, und, wenn k=0 oder 1 ist, die Softbit-Information des variablen Knotens n in der (k-1)-ten Schicht die zu dekodierende Softbit-Information des variablen Knotens n in der Basismatrix ist.

2. Dekodierer nach Anspruch 1, wobei beim Bestimmen der Variabler-Knoten-Informationen vom variablen Knoten n zum Prüfknoten m in der (k+1)-ten Schicht der Basismatrix gemäß der Softbit-Information des variablen Knotens n in der (k-1)-ten Schicht der Basismatrix die Recheneinheit für folgende Vorgänge ausgelegt ist:
   Subtrahieren von Prüfknoteninformationen vom variablen Knoten n zum Prüfknoten m in der k-ten Schicht der Basismatrix in der letzten Iteration von den Softbit-Informationen des variablen Knotens n in der (k-1)-ten Schicht der Basismatrix, und Addieren von Prüfknoteninformationen vom variablen Knoten n zum Prüfknoten m in der k-ten Schicht der Basismatrix zum Erhalten eines Wertes, der als die Softbit-Information des variablen Knotens n in der k-ten Schicht der Basismatrix bestimmt ist.

3. Dekodierer nach Anspruch 1, wobei beim Bestimmen der Variabler-Knoten-Informationen vom variablen Knoten n zum Prüfknoten m in der (k+1)-ten Schicht der Basismatrix gemäß der Softbit-Information des variablen Knotens n in der (k-1)-ten Schicht der Basismatrix die Recheneinheit für folgende Vorgänge ausgelegt ist:
Subtrahieren von Prüfknoteninformationen vom variablen Knoten n zum Prüfknoten m in der (k+1)-ten Schicht der Basismatrix in einer letzten Iteration von der Softbit-Information des variablen Knotens n in der (k-1)-ten Schicht der Basismatrix und Bestimmen eines Differenzwertes, der als die Variabler-Knoten-Informationen vom variablen Knoten n zum Prüfknoten m in der (k+1)-ten Schicht der Basismatrix erhalten wird.

4. Dekodierer nach Anspruch 1, ferner umfassend eine Vorverarbeitungseinheit, die mit der Recheneinheit verbunden ist, und bevor die Recheneinheit die zu dekodierende Softbit-Information des variablen Knotens n erfasst, die Vorverarbeitungseinheit für folgende Vorgänge ausgelegt ist:
Erfassen der zu dekodierenden Softbit-Informationen; und Vorverarbeiten der zu dekodierenden Softbit-Informationen zum Erhalten der zu dekodierenden Softbit-Informationen des variablen Knotens n.

5. Dekodierer nach Anspruch 4, wobei die Vorverarbeitungseinheit eine Formatumwandlungseinheit, eine Routing-Einheit, eine Flussleitungssteuereinheit, mindestens eine Positivverschiebungseinheit und mindestens eine Speichereinheit umfasst; wobei die Formatumwandlungseinheit mit der mindestens einen Speichereinheit verbunden ist, die mindestens eine Speichereinheit mit der mindestens einen Positivverschiebungseinheit verbunden ist, die mindestens eine Positivverschiebungseinheit mit der Routing-Einheit verbunden ist, die Routing-Einheit mit der mindestens einen Recheneinheit verbunden ist, die Flussleitungssteuereinheit mit der mindestens einen Positivverschiebungseinheit bzw. der mindestens einen Recheneinheit verbunden ist, und die Positivverschiebungseinheit der Speichereinheit eins zu eins entspricht;

die Formatumwandlungseinheit dafür ausgelegt ist, Blockteilung an den zu dekodierenden Softbit-Informationen zum Erhalten mindestens eines zu dekodierenden Softbit-Informationsblocks durchzuführen, und den mindestens einen zu dekodierenden Softbit-Informationsblock an eine entsprechende Speichereinheit zur Speicherung zu senden;
die Speichereinheit dafür ausgelegt ist, den zu dekodierenden Softbit-Informationsblock zu empfangen und in Gruppen zu speichern;
die Flussleitungssteuereinheit dafür ausgelegt ist, zu bestimmen, dass die Positivverschiebungseinheit die zu dekodierenden Softbit-Informationen empfängt und die Positivverschiebungseinheit auslöst, und die Positivverschiebungseinheit dafür ausgelegt ist, positive zyklische Verschiebung an den zu dekodierenden Softbit-Informationen zum Erhalten verschobener zu dekodierender Softbit-Informationen durchzuführen; und die Routing-Einheit dafür ausgelegt ist, die verschobenen zu dekodierenden Softbit-Informationen an die mindestens eine Recheneinheit gemäß einem voreingestellten Routing-Modus auszugeben, so dass die Recheneinheit die zu dekodierenden Softbit-Informationen des variablen Knotens n erfasst.

6. Dekodierer nach Anspruch 5, wobei beim Durchführen von Blockteilung für die zu dekodierenden Softbit-Informationen zum Erhalten mindestens einer zu dekodierenden Softbit-Information und beim Senden des mindestens einen Softbit-Informationsblocks an die entsprechende Speichereinheit zur Speicherung die Formatumwandlungseinheit für folgende Vorgänge ausgelegt ist:

Aufteilen der zu dekodierenden Softbit-Information in b zu dekodierende Softbit-Informationsblöcke entsprechend der Anzahl von Spalten b der Basismatrix; wobei jeder zu dekodierende Softbit-Informationsblock einem Elementwert der n-ten Spalte der Basismatrix entspricht; und
Speichern der zu dekodierenden Softbit-Informationsblöcke, die Spalten mit Orthogonalität in der Basismatrix entsprechen, in derselben Speichereinheit wie die zu dekodierenden b Softbit-Informationsblöcke.

7. Dekodierer nach Anspruch 5, wobei beim Empfangen und Speichern der zu dekodierenden Softbit-Informationsblöcke in Gruppen die Speichereinheit für folgende Vorgänge ausgelegt ist:

Aufteilen der zu dekodierenden Softbit-Informationsblöcke in Z zu dekodierende Softbit-Informationen, Gruppieren der zu dekodierenden Z Softbit-Informationen entsprechend einem voreingestellten Betrag von Dekodierparallelität P in jeder Gruppe und Speichern der Z Softbit-Informationen in der Speichereinheit;
wobei Z ein Erweiterungsfaktor der Basismatrix und eine positive ganze Zahl ist.

8. Dekodierer nach Anspruch 5, wobei beim Durchführen von positiver zyklischer Verschiebung für die zu dekodierenden Softbit-Informationen zum Erhalten der zu dekodierenden verschobenen Softbit-Informationen die Positivverschiebungseinheit für folgende Vorgänge ausgelegt ist:
Bestimmen eines entsprechenden Verschiebungswertes gemäß einem Elementwert in der k-ten Zeile der Basismatrix; und Durchführen von positiver zyklischer Verschiebung der empfangenen zu dekodierenden Softbit-Informationen entsprechend dem Verschiebungswert zum Erhalten der verschobenen zu dekodierenden Softbit-Informationen.

9. Dekodierer nach Anspruch 5, ferner umfassend mindestens eine Invers-Verschiebungseinheit, die mit der mindestens einen Speichereinheit, der Routing-Einheit bzw. der Flussleitungssteuereinheit verbunden ist, wobei die mindestens eine Invers-Verschiebungseinheit der mindestens einen Speichereinheit eins zu eins entspricht; die Routing-Einheit für folgende Vorgänge ausgelegt ist:

    bis die Anzahl von Dekodieriterationen i gleich dem voreingestellten Dekodieriterationsschwellenwert ist, Empfangen des Dekodierergebnisses von der mindestens einen Recheneinheit, und Ausgeben des Dekodierergebnisses an die mindestens eine Invers-Verschiebungseinheit gemäß dem voreingestellten Routing-Modus; und die Flussleitungssteuereinheit dafür ausgelegt ist, zu bestimmen, dass die Invers-Verschiebungseinheit das Dekodierergebnis empfängt und die Invers-Verschiebungseinheit auslöst, und die Invers-Verschiebungseinheit dafür ausgelegt ist, inverse zyklische Verschiebung am Dekodierergebnis durchzuführen und das Dekodierergebnis entsprechend dem Verschiebungswert der entsprechenden Speichereinheit verschoben an die entsprechende Speichereinheit auszugeben.

10. Dekodierverfahren, das in mindestens einer Recheneinheit eines Dekodierers angewendet wird, **dadurch gekennzeichnet, dass** das Verfahren folgende Vorgänge umfasst:

    Erfassen von zu dekodierenden Softbit-Informationen eines variablen Knotens n in einer Schicht einer Basismatrix eines "Low-Density Parity-Check"-, LDPC-, Codes (S1001), wobei n eine ganze Zahl größer oder gleich 0 und kleiner als eine Anzahl von Spalten b der Basismatrix ist;
    Bestimmen, ob eine Anzahl von Dekodieriterationen i des LDPC-Codes kleiner ist als ein voreingestellter Dekodieriterationsschwellenwert (S1002);
    als Reaktion darauf, dass die Anzahl von Dekodieriterationen i kleiner als der voreingestellte Dekodieriterationsschwellenwert bestimmt wird, Bestimmen, ob eine Anzahl von Dekodierschichten k des LDPC-Codes kleiner als eine Anzahl von Zeilen a der Basismatrix ist (S1003);
    als Reaktion darauf, dass die Anzahl von Dekodierschichten k des LDPC-Codes kleiner ist als die Anzahl von Zeilen a der Basismatrix, Bestimmen von Softbit-Informationen eines variablen Knotens n in einer k-ten Schicht der Basismatrix gemäß den Softbit-Informationen eines variablen Knotens n in einer (k-1)-ten Schicht der Basismatrix, einer Prüfknoteninformation von einem variablen Knoten n zu einem Prüfknoten m in einer k-ten Schicht der Basismatrix in einer (i-1)-ten Dekodieriteration und einer Prüfknoteninformation vom variablen Knoten n zum Prüfknoten m in der k-ten Schicht der Basismatrix, und Bestimmen von Variabler-Knoten-Informationen von einem variablen Knoten n zu einem Prüfknoten m in einer (k+1)-ten Schicht der Basismatrix gemäß den Softbit-Informationen des variablen Knotens n in der (k-1)-ten Schicht der Basismatrix und einer Prüfknoteninformation von einem variablen Knoten n zu einem Prüfknoten m in einer (k+1)-ten Schicht der Basismatrix in der (i-1)-ten Dekodieriteration (S1004);
    Bestimmen von Prüfknoteninformationen vom Prüfknoten m zum variablen Knoten n in der (k+1)-ten Schicht der Basismatrix entsprechend Variabler-Knoten-Informationen aller variablen Knoten, die mit dem Prüfknoten m in der (k+1)-ten Schicht verbunden sind, außer dem variablen Knoten n (S1005);
    Aktualisieren der Anzahl von Dekodierschichten k auf k+1 (S1006) und erneutes Bestimmen, ob die Anzahl von Dekodierschichten k des LDPC-Codes kleiner ist als die Anzahl von Zeilen a der Basismatrix; und
    als Reaktion darauf, dass die Anzahl von Dekodierschichten k größer oder gleich der Anzahl von Zeilen a der Basismatrix ist, Aktualisieren der Anzahl von Dekodieriterationen i auf i+1 (S1007) und erneutes Bestimmen, ob die Anzahl von Dekodieriterationen i des LDPC-Codes kleiner als der voreingestellte Dekodieriterationsschwellenwert ist, bis die Anzahl von Dekodieriterationen i gleich dem voreingestellten Dekodieriterationsschwellenwert ist, Bestimmen der Softbit-Informationen des variablen Knotens n in der k-ten Schicht als ein Dekodierergebnis der zu dekodierenden Softbit-Informationen des variablen Knotens n in der Basismatrix (S1008);
    wobei, wenn i einen Anfangswert von 0 hat, k einen Anfangswert von 0 hat, und, wenn k=0 oder 1 ist, die Softbit-Information des variablen Knotens n in der (k-1)-ten Schicht die zu dekodierende Softbit-Information des variablen Knotens n in der Basismatrix ist.

11. Verfahren nach Anspruch 10, wobei das Bestimmen der Variabler-Knoten-Informationen vom variablen Knoten n zum Prüfknoten m in der (k+1)-ten Schicht der Basismatrix gemäß der Softbit-Information des variablen Knotens n in der (k-1)-ten Schicht der Basismatrix umfasst:

Subtrahieren von Prüfknoteninformationen vom variablen Knoten n zum Prüfknoten m in der k-ten Schicht der Basismatrix in der letzten Iteration von den Softbit-Informationen des variablen Knotens n in der (k- 1)-ten Schicht der Basismatrix, und Addieren von Prüfknoteninformationen vom variablen Knoten n zum Prüfknoten m in der k-ten Schicht der Basismatrix zum Erhalten eines Wertes, der als die Softbit-Information des variablen Knotens n in der k-ten Schicht der Basismatrix bestimmt ist.

12. Dekodierverfahren nach Anspruch 10, wobei das Bestimmen der Variabler-Knoten-Informationen vom variablen Knoten n zum Prüfknoten m in der (k+1)-ten Schicht der Basismatrix gemäß der Softbit-Information des variablen Knotens n in der (k-1)-ten Schicht der Basismatrix umfasst:
Subtrahieren von Prüfknoteninformationen vom variablen Knoten n zum Prüfknoten m in der (k+1)-ten Schicht der Basismatrix in einer letzten Iteration von der Softbit-Information des variablen Knotens n in der (k-1)-ten Schicht der Basismatrix und Bestimmen eines Differenzwertes, der als die Variabler-Knoten-Informationen vom variablen Knoten n zum Prüfknoten m in der (k+1)-ten Schicht der Basismatrix erhalten wird.

13. Computerspeichermedium mit einem darauf gespeicherten Computerprogramm, das Anweisungen umfasst, die bei ihrer Ausführung durch einen Prozessor den Prozessor veranlassen, das Dekodierverfahren nach einem der Ansprüche 10 bis 12 durchzuführen.

## Revendications

1. Décodeur, comprenant au moins une unité informatique, **caractérisé en ce que** cette unité informatique est configurée de façon à :

acquérir des informations binaires temporaires à décoder d'un noeud variable n dans une couche d'une matrice de base d'un code de contrôle de parité à faible densité, LDPC, (S1001), n étant un nombre entier plus grand que ou égal à 0 et moins qu'une quantité de colonnes b de la matrice de base ;
déterminer si une quantité d'itérations de décodage i du code LDPC est moins qu'un seuil d'itérations de décodage prédéfini (S1002) ;
en réponse à la quantité d'itérations de décodage i étant déterminée comme étant moins que le seuil d'itérations de décodage prédéfini, déterminer si une quantité de couches de décodage k du code LDPC est moins qu'une quantité de rangées a de la matrice de base (S1003) ;
en réponse à la quantité de couches de décodage k du code LDPC étant moins que la quantité de rangées a de la matrice de base, déterminer les informations binaires temporaires d'un noeud variable n dans une $k^{ième}$ couche de la matrice de base selon les informations binaires temporaires d'un noeud variable n dans une (k - 1)$^{ième}$ couche de la matrice de base, des informations d'un noeud de contrôle allant d'un noeud variable n à un noeud de contrôle m dans une $k^{ième}$ couche de la matrice de base dans une itération de décodage (i - 1)$^{ième}$ et des informations d'un noeud de contrôle allant du noeud variable n au noeud de contrôle m dans la $k^{ième}$ couche de la matrice de base, et déterminer des informations de noeud variable allant d'un noeud variable n à un noeud de contrôle m dans une (k + 1)$^{ième}$ couche de la matrice de base selon les informations binaires temporaires du noeud variable n dans la (k - 1)$^{ième}$ couche de la matrice de base et des informations d'un noeud de contrôle allant d'un noeud variable n à un noeud de contrôle m dans une (k + 1)$^{ième}$ couche de la matrice de base dans l'itération de décodage (i - 1)$^{ième}$ (S1004) ;
déterminer des informations de noeud de contrôle allant du noeud de contrôle m au noeud variable n dans la (k + 1) $^{ième}$ couche de la matrice de base selon des informations de noeuds variables de tous les noeuds variables connectés au noeud de contrôle n dans la (k + 1)$^{ième}$ couche sauf le noeud variable n (S1005) ;
mettre à jour la quantité de couches de décodage de k à k + 1 (S1006), et redéterminer si la quantité de couches de décodage k du code LDPC est moins que la quantité de rangées a de la matrice de base ; et de façon à
en réponse à la quantité de couches de décodage k étant plus grande que ou égale à la quantité de rangées a de la matrice de base, mettre à jour la quantité d'itérations de décodage de i à i + 1 (S1007), et redéterminer si la quantité d'itérations de décodage i du code LDPC est moins que le seuil d'itérations de décodage prédéfini, jusqu'à ce que la quantité d'itérations de décodage i soit égale au seuil d'itérations de décodage prédéfini, déterminer les informations binaires temporaires du noeud variable n dans la $k^{ième}$ couche comme un résultat de décodage des informations binaires temporaires à décoder du noeud variable n dans la matrice de base (S1008) ;
décodeur dans lequel, lorsque i a une valeur initiale de 0, k a une initiale de 0, et lorsque k = 0 ou 1, les informations binaires temporaires du noeud variable n dans la k - 1$^{ième}$ couche sont les informations binaires temporaires à décoder du noeud variable n dans la matrice de base.

**2.** Décodeur selon la revendication 1, dans lequel, en déterminant les informations de noeud variable allant du noeud variable n au noeud de contrôle m dans la $(k + 1)^{ième}$ couche de la matrice de base selon les informations binaires temporaires du noeud variable n dans la $(k - 1)^{ième}$ couche de la matrice de base, l'unité informatique est configurée de façon à :

soustraite des informations de noeud de contrôle allant du noeud variable n au noeud de contrôle m dans la $k^{ième}$ couche de la matrice de base dans la dernière itération des informations binaires temporaires du noeud variable n dans la $(k - 1)^{ième}$ couche de la matrice de base, et de façon à additionner des informations de noeud de contrôle allant du noeud variable n au noeud de contrôle m dans la $k^{ième}$ couche de la matrice de base, afin d'obtenir une valeur déterminée comme les informations binaires temporaires du noeud variable n dans la $k^{ième}$ couche de la matrice de base.

**3.** Décodeur selon la revendication 1, dans lequel, en déterminant les informations de noeud variable allant du noeud variable n au noeud de contrôle m dans la $(k + 1)^{ième}$ couche de la matrice de base selon les informations binaires temporaires du noeud variable n dans la $(k - 1)^{ième}$ couche de la matrice de base, l'unité informatique est configurée de façon à :

soustraire des informations de noeud de contrôle allant du noeud variable n au noeud de contrôle m dans la $(k + 1)^{ième}$ couche de la matrice de base dans une dernière itération des informations binaires temporaires du noeud variable n dans la $(k - 1)^{ième}$ couche de la matrice de base, et de façon à déterminer une valeur de différence obtenue comme les informations de noeud variable allant du noeud variable n au noeud de contrôle m dans la $(k + 1)^{ième}$ couche de la matrice de base.

**4.** Décodeur selon la revendication 1, comprenant en outre une unité de prétraitement connectée à l'unité informatique, et, avant que l'unité informatique n'acquière les informations binaires temporaires à décoder du noeud variable n, cette unité de prétraitement est configurée de façon à :

acquérir les informations binaires temporaires à décoder ; et de façon à
prétraiter les informations binaires temporaires à décoder afin d'obtenir les informations binaires temporaires à décoder du noeud variable n.

**5.** Décodeur selon la revendication 4, dans lequel l'unité de prétraitement comprend une unité de conversion de format, une unité de routage, une unité de commande de ligne de flux, au moins une unité de décalage positif et au moins une unité de stockage ; l'unité de conversion de format étant connectée à l'au moins une unité de stockage, l'au moins une unité de stockage étant connectée à l'au moins une unité de décalage positif, l'au moins une unité de décalage positif étant connectée à l'unité de routage, l'unité de routage étant connectée à l'au moins une unité informatique, l'unité de commande de ligne de flux étant connectée à l'au moins une unité de décalage positif et à l'au moins une unité informatique respectivement, et l'unité de décalage positif correspondant à l'unité de stockage une à une ;

l'unité de conversion de format étant configurée de façon à exécuter une division en blocs sur les informations binaires temporaires à décoder afin d'obtenir au moins un bloc d'informations binaires temporaires à décoder, et de façon à envoyer cet au moins un bloc d'informations binaires temporaires à décoder à une unité de stockage correspondante pour le stocker ;
l'unité de stockage étant configurée de façon à recevoir et à stocker en groupes le bloc d'informations binaires temporaires à décoder ;
l'unité de commande de ligne de flux étant configurée de façon à déterminer que l'unité de décalage positif reçoit les informations binaires temporaires à décoder et déclenche l'unité de décalage positif, et l'unité de décalage positif étant configurée de façon à exécuter un décalage cyclique positif sur les informations binaires temporaires à décoder afin d'obtenir des informations binaires temporaires décalées à décoder ; et
l'unité de routage étant configurée de façon à fournir les informations binaires temporaires décalées à décoder à l'au moins une unité informatique selon un mode de routage prédéfini, de manière à ce que l'unité informatique acquière les informations binaires temporaires à décoder du noeud variable n.

**6.** Décodeur selon la revendication 5, dans lequel, en exécutant une division en blocs pour les informations binaires temporaires à décoder afin d'obtenir au moins une information binaire temporaire à décoder, et en envoyant cet au moins un bloc d'informations binaires temporaires à l'unité de stockage correspondante pour le stocker, l'unité de conversion de format est configurée de façon à :

diviser les informations binaires temporaires à décoder en b blocs d'informations binaires temporaires à décoder selon la quantité de colonnes b de la matrice de base ; chaque bloc d'informations binaires temporaires à décoder correspondant à une valeur d'élément de la $n^{ième}$ colonne de la matrice de base ; et de façon à stocker les blocs d'informations binaires temporaires à décoder correspondant à des colonnes avec une orthogonalité dans la matrice de base dans la même unité de stockage parmi les b blocs d'informations binaires temporaires à décoder.

7. Décodeur selon la revendication 5, dans lequel, en recevant et en stockant dans des groupes les blocs d'informations binaires temporaires à décoder, l'unité de stockage est configurée de façon à :

   diviser les blocs d'informations binaires temporaires à décoder en Z informations binaires temporaires à décoder, grouper les Z informations binaires temporaires à décoder selon une quantité prédéfinie de parallélisme de décodage P dans chaque groupe, et stocker les Z informations binaires temporaires dans l'unité de stockage ; Z étant un facteur d'extension de la matrice de base et un nombre entier positif.

8. Décodeur selon la revendication 5, dans lequel, en exécutant un décalage cyclique positif pour les informations binaires temporaires à décoder afin d'obtenir les informations binaires temporaires décalées à décoder, l'unité de décalage positif est configurée de façon à :

   déterminer une valeur de décalage correspondante selon une valeur d'élément dans la $k^{ième}$ rangée de la matrice de base ; et de façon à exécuter un décalage cyclique positif sur les informations binaires temporaires reçues à décoder selon la valeur de décalage afin d'obtenir les informations binaires temporaires décalées à décoder.

9. Décodeur selon la revendication 5, comprenant en outre au moins une unité de décalage inverse connectée à l'au moins une unité de stockage, à l'unité de routage et à l'unité de commande de ligne de flux respectivement, et l'au moins une unité de décalage inverse correspondant à l'au moins une unité de stockage une à une ;

   l'unité de routage étant configurée de façon à : jusqu'après que la quantité d'itérations de décodage i est égale au seuil d'itérations de décodage prédéfini, recevoir le résultat de décodage de l'au moins une unité informatique, et fournir le résultat de décodage à l'au moins une unité de décalage inverse selon le mode de routage prédéfini ; et l'unité de commande de ligne de flux étant configurée de façon à déterminer que l'unité de décalage inverse reçoit le résultat de décodage et déclenche l'unité de décalage inverse, et l'unité de décalage inverse étant configurée de façon à exécuter un décalage cyclique inverse sur le résultat de décodage et à fournir le résultat de décodage décalé à l'unité de stockage correspondante selon la valeur de décalage de l'unité de stockage correspondante.

10. Procédé de décodage appliqué dans au moins une unité informatique d'un décodeur, **caractérisé en ce que** ce procédé comprend :

    l'acquisition d'informations binaires temporaires à décoder d'un noeud variable n dans une couche d'une matrice de base d'un code de contrôle de parité à faible densité, LDPC, (S1001), n étant un nombre entier plus grand que ou égal à 0 et moins qu'une quantité de colonnes b de la matrice de base ;
    la détermination de si une quantité d'itérations de décodage i du code LDPC est moins qu'un seuil d'itérations de décodage prédéfini (S1002) ;
    en réponse à la quantité d'itérations de décodage i étant moins que le seuil d'itérations de décodage prédéfini, la détermination de si une quantité de couches de décodage k du code LDPC est moins qu'une quantité de rangées a de la matrice de base (S1003) ;
    en réponse à la quantité de couches de décodage k du code LDPC étant moins que la quantité de rangées a de la matrice de base, la détermination des informations binaires temporaires d'un noeud variable n dans une $k^{ième}$ couche de la matrice de base selon les informations binaires temporaires d'un noeud variable n dans une $(k - 1)^{ième}$ couche de la matrice de base, des informations d'un noeud de contrôle allant d'un noeud variable n au noeud de contrôle m dans une $k^{ième}$ couche de la matrice de base dans une itération de décodage $(i - 1)^{ième}$ et des informations d'un noeud de contrôle allant du noeud variable n au noeud de contrôle m dans la $k^{ième}$ couche de la matrice de base, et la détermination d'informations de noeud variable allant d'un noeud variable n à un noeud de contrôle m dans une $(k + 1)^{ième}$ couche de la matrice de base selon les informations binaires temporaires du noeud variable n dans la $(k - 1)^{ième}$ couche de la matrice de base et des informations d'un noeud de contrôle allant d'un noeud variable n à un noeud de contrôle m dans une $(k + 1)^{ième}$ couche de la matrice de base dans l'itération de décodage (i - 1)ième (S1004) ;

la détermination d'informations de noeud de contrôle allant du noeud de contrôle m au noeud variable n dans la (k + 1) ième couche de la matrice de base selon des informations de noeuds variables de tous les noeuds variables connectés au noeud de contrôle m dans la (k + 1)ième couche sauf le noeud variable n (S1005) ;

la mise à jour de la quantité de couches de décodage de k à k + 1 (S1006), et la re-détermination de si la quantité de couches de décodage k du code LDPC est moins que la quantité de rangées a de la matrice de base ; et

en réponse à la quantité de couches de décodage k étant plus grande que ou égale à la quantité de rangées a de la matrice de base, la mise à jour de la quantité i d'itérations de décodage à i + 1 (S1007), la re-détermination de si la quantité d'itérations de décodage i du code LDPC est moins que le seuil d'itérations de décodage prédéfini, jusqu'à ce que la quantité d'itérations de décodage i soit égale au seuil d'itérations de décodage prédéfini, et la détermination des informations binaires temporaires du noeud variable n dans la kième couche comme un résultat de décodage des informations binaires temporaires à décoder du noeud variable n dans la matrice de base (S1008) ;

procédé dans lequel, lorsque i a une valeur initiale de 0, k a une initiale de 0, et lorsque k = 0 ou 1, les informations binaires temporaires du noeud variable n dans la (k - 1)ième couche sont les informations binaires temporaires à décoder du noeud variable n dans la matrice de base.

11. Procédé selon la revendication 10, dans lequel la détermination des informations de noeud variable allant du noeud variable n au noeud de contrôle m dans la (k + 1)ième couche de la matrice de base selon les informations binaires temporaires du noeud variable n dans la (k - 1)ième couche de la matrice de base comprend :
la soustraction d'informations de noeud de contrôle allant du noeud variable n au noeud de contrôle m dans la kième couche de la matrice de base dans la dernière itération des informations binaires temporaires du noeud variable n dans la (k - 1)ième couche de la matrice de base, et l'addition d'informations de noeud de contrôle allant du noeud variable n au noeud de contrôle m dans la kième couche de la matrice de base, afin d'obtenir une valeur déterminée comme les informations binaires temporaires du noeud variable n dans la kième couche de la matrice de base.

12. Procédé de décodage selon la revendication 10, dans lequel la détermination des informations binaires temporaires allant du noeud variable n au noeud de contrôle m dans la (k + 1)ième couche de la matrice de base selon les informations binaires temporaires du noeud variable n dans la (k - 1)ième couche de la matrice de base comprend la soustraction d'informations de noeud de contrôle allant du noeud variable n au noeud de contrôle m dans la (k + 1)ième couche de la matrice de base dans une dernière itération des informations binaires temporaires du noeud variable n dans la (k - 1)ième couche de la matrice de base, et la détermination d'une valeur de différence obtenue comme les informations de noeud variable allant du noeud variable n au noeud de contrôle m dans la (k + 1)ième couche de la matrice de base.

13. Support de stockage informatique, ayant un programme informatique stocké sur lui comprenant des instructions qui, lorsqu'elles sont exécutées par un processeur, font exécuter à ce processeur le procédé de décodage selon l'une quelconque des revendications 10 à 12.

FIG. 1

Computing
unit

FIG. 2

| | VN0 | VN1 | VN2 | VN3 | VN4 | VN5 | VN6 | VN7 | VN8 |
|---|---|---|---|---|---|---|---|---|---|
| Layer0 | 4 | 6 | 5 | 11 | 0 | -1 | -1 | -1 | -1 |
| Layer1 | 15 | -1 | 9 | -1 | -1 | 0 | -1 | -1 | -1 |
| Layer2 | -1 | 8 | 2 | -1 | -1 | -1 | 0 | -1 | -1 |
| Layer3 | 10 | -1 | -1 | 7 | -1 | -1 | -1 | 0 | -1 |
| Layer4 | -1 | 4 | 6 | -1 | -1 | -1 | -1 | -1 | 0 |

FIG. 3

| | | | | |
|---|---|---|---|---|
| Addr3 | $LLR_7$ | $LLR_{11}$ | $LLR_{15}$ | $LLR_3$ |
| Addr2 | $LLR_{10}$ | $LLR_{14}$ | $LLR_2$ | $LLR_6$ |
| Addr1 | $LLR_{13}$ | $LLR_1$ | $LLR_5$ | $LLR_9$ |
| Addr0 | $LLR_0$ | $LLR_4$ | $LLR_8$ | $LLR_{12}$ |
| | RAM 0 | RAM 1 | RAM 2 | RAM 3 |

FIG. 4

Storage unit 0

Storage unit 1

Storage unit 2

Storage unit 3

Storage unit 4

FIG. 5

Shift unit 0

Shift unit 1

Shift unit 2

Shift unit 3

Shift unit 4

FIG. 6

FIG. 7

FIG. 8

FIG. 9

S1001

Acquire soft bit information to be decoded of a variable node n in a basic matrix of a LDPC code

S1002

Determine whether the number of decoding iterations i of the LDPC code is less than a preset decoding iteration threshold

S1008

The number of decoding iterations i is equal to the decoding iteration threshold, determine the soft bit information of the variable node n in the $k^{th}$ layer as a decoding result of the soft bit information to be decoded of the variable node n

The number of decoding iterations i is less than the decoding iteration threshold

S1003

Determine whether the number of decoding layers k of the LDPC code is less than the number of rows a of the basic matrix

S1004

In response to the number of decoding layers k being less than the number of rows a of the basic matrix, determine soft bit information of a variable node n in a $k^{th}$ layer of the basic matrix according to soft bit information of a variable node n in a k-1$^{th}$ layer of the basic matrix , and determine variable node information from a variable node n to a check node m in a k+1$^{th}$ layer of the basic matrix according to the soft bit information of the variable node n in the k-1$^{th}$ layer of the basic matrix

S1007

In response to the number of decoding layers k Being greater than or equal to the number of rows a of the basic matrix, update the number of iterations i to i+1

S1005

Determine check node information from the check node m to the variable node n in the k+1$^{th}$ layer of the basic matrix according to the variable node information from the variable node n to the check node m in the k+1$^{th}$ layer of the basic matrix

S1006

Update the number of decoding layers k to k+1

FIG. 10

Computer
storage medium
110

FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2017230058 A1